# EUROPEAN PATENT SPECIFICATION

(11) **EP 2 326 032 B1**
(45) Date of publication and mention of the grant of the patent: **25.07.2012**
(21) Application number: 10014262.9
(22) Date of filing: 03.11.2010
(51) Int. Cl.: H04B 10/12, H01S 5/40

(54) **Optical transmitter for mm-wave RoF systems and corresponding method**
Optischer Sender für mm-Wellen-RoF-Systeme und entsprechendes Verfahren
Transmetteur optique pour systèmes RoF à ondes mm et procédé correspondant

(30) Priority: 20.11.2009 US 263124 P; 25.02.2010 US 712758
(43) Date of publication of application: 25.05.2011
(73) Proprietor: Corning Cable Systems LLC, Hickory NC 28602 (US)
(72) Inventor: Seldon D, Benjamin, Painted Post NY 14870 (US); Fortusini, Davide, D., Ithaca, NY 14850 (US); Ng'oma, Anthony, Painted Post, NY 14870 (US); Sauer, Michael, Corning, NY 14830 (US)
(74) Representative: Sturm, Christoph

(56) References cited:
- HYUK-KEE SUNG ET AL: "Optical Single Sideband Modulation Using Strong Optical Injection-Locked Semiconductor Lasers", IEEE PHOTONICS TECHNOLOGY LETTERS, IEEE SERVICE CENTER, PISCATAWAY, NJ, US, vol. 19, no. 13, 1 July 2007 (2007-07-01), pages 1005-1007, XP011185268, ISSN: 1041-1135, DOI: DOI:10.1109/LPT.2007.898760
- BO ZHANG ET AL: "Reconfigurable Multifunctional Operation Using Optical Injection-Locked Vertical-Cavity Surface-Emitting Lasers", JOURNAL OF LIGHTWAVE TECHNOLOGY, IEEE SERVICE CENTER, NEW YORK, NY, US, vol. PP, no. 15, 1 August 2009 (2009-08-01), pages 2958-2963, XP011256281, ISSN: 0733-8724
- LU H H ET AL: "Improvement of radio-on-multimode fiber systems based on light injection and optoelectronic feedback techniques", OPTICS COMMUNICATIONS, NORTH-HOLLAND PUBLISHING CO. AMSTERDAM, NL, vol. 266, no. 2, 15 October 2006 (2006-10-15), pages 495-499, XP025252038, ISSN: 0030-4018, DOI: DOI:10.1016/J.OPTCOM.2006.05.009 [retrieved on 2006-10-15]
- CHENG ZHANG ET AL: "60 GHz millimeter-wave generation by two-mode injection-locked Fabry-Perot laser using second-order sideband injection in radio-over-fiber system", LASERS AND ELECTRO-OPTICS, 2008. CLEO 2008. CONFERENCE ON, IEEE, PISCATAWAY, NJ, USA, 4 May 2008 (2008-05-04), pages 1-2, XP031278802, ISBN: 978-1-55752-859-9

## Description

### PRIORITY APPLICATION

This application claims the benefit of U.S. Provisional Application No. 61/263,124, filed November 20, 2009.

### BACKGROUND

### Technical Field

The disclosure relates to optical transmission devices, and more particularly to optically injection-locked semiconductor laser devices for high speed optical transmission.

### Technical Background

Optically injection-locked (OIL) semiconductor lasers are promising optical sources for high-speed optical transmission because they exhibit enhanced frequency response, and are therefore suitable for direct modulation. The enhanced frequency response is of particular importance for multi-Gbps fiber-wireless systems operating at millimeter wave frequencies, such as 60 GHz. In optical injection-locking, the optical output from a master laser is injected into a slave laser. Under particular conditions, the slave laser is "locked" to the master, i.e., the laser emission of the slave laser is locked in optical frequency and phase to the optical field of the master laser. Under these conditions, enhancement of the slave laser's characteristics can be obtained. A particularly interesting class of low-cost OIL sources is represented by OIL Vertical-Cavity Surface-Emitting Lasers (VCSELs), in which the slave laser is a VCSEL.

For a given slave laser, the frequency response depends on the OIL condition, which is characterized by two parameters: 1) the frequency detuning (difference in optical frequency between the master laser and the free-running slave laser) and 2) the injection ratio (ratio of master laser optical power to slave laser optical power). With an appropriate choice of these parameters, the frequency response of the OIL VCSEL shows a resonance peak that enhances the response at high frequency. In such a condition, the frequency response of the VCSEL can be tuned to low-pass or bandpass at a higher frequency. Moreover, the OIL VCSEL produces a single-sideband (SSB) modulation. The bandpass frequency response and the single-sideband modulation make the OIL VCSEL particularly suitable for use in radio-over-fiber (RoF) systems as an optical transmitter to generate an optical signal that can be transported to a remote antenna unit by means of an optical fiber.

One important drawback of known OIL VCSEL devices is that the attainable modulation depth (i.e., the ratio between the modulated signal power and the optical carrier power) is very small. This drawback arises from the fact that the optical output of the OIL VCSEL is spatially and spectrally coincident with the master laser's optical power, which is reflected by the VCSEL itself. The reflected master optical power is unmodulated, and it has substantially higher power than the modulated power emitted by the VCSEL. Consequently, the resulting optical signal consists of a very strong optical carrier and a much weaker modulated sideband. In general, weakly modulated optical signals lead to poor link efficiency because the imbalance between the optical carrier and the modulated sideband leads to a poor signal-to-noise ratio (SNR) of the detected electrical/RF signal, thus causing a high BER (bit error rate). It has been established that the best link efficiency is often obtained when the power in the carrier and the sideband(s) are approximately equal.

HYUK-KEE SUNG ET al: "Optical single sideband Modulation using Strong Optical Injection-Locked Semiconductor Lasers", IEEE PHOTONICS TECHNOLOGY LETTERS, IEEE SERVICE CENTER, PISCATAWAY, NJ, US, vol. 19, no. 13, 1 July 2007 (2001-07-01), pages 1005-1007, XP011185268, ISSN: 1041-1135, DOI: DOI:10.1109/LPT.2007.898760, reports on the experimental demonstration of optical single sideband (SSB) modulation using a directly modulated semiconductor laser under strong optical injection-locking. Modulation sidebands with 15-dB power ratio between the lower and upper sidebands have been reported. The longer wavelength sideband is resonantly amplified by the injection-locked laser cavity mode.

BO ZHANG ET AL: "Reconfigurable Multifunctional Operating Using Optical injection-Locked Vertical-Cavity Surface-Emitting Lasers", JOURNAL OF LIGHTWAVE TEHCNOLOGY, IEEE SERVICE CENTER, NEW YORK, NY, US, vol. PP, no. 15, 1 August 2009 (2009-08-01), pages 2958-2963, XP011256281, ISSN: 0733-8724 further reports on an extension of the system application of optical injection-locked (OIL) Vertical-Cavity Surface-Emitting Lasers (VCSELs) to future optical networks by realizing multifunctional operation using a filter-assisted OIL-VCSEL scheme that can be reconfigured. By using a single chirp-adjustable injection-locked VCSEL followed by a tunable delay line interferometer, three functions showing ultra-wideband monocycle generation, nonretum-to-zero (NRZ) to pseudoreturn-to-zero (PRZ) data format conversion, and NRZ-data clock recovery at 10 Gb/s is experimentally demonstrated.

In Mach-Zehnder modulated systems, which are the most widely employed RoF systems for high frequency operation, the relative optical powers between the carrier and the sideband(s) are often controlled by tuning the modulator bias voltage. However, in OIL devices, this limitation cannot be overcome by reducing the power of the master laser or increasing the output power of the VCSEL, because doing so would modify the injection ratio away from the value necessary to obtain the desired frequency response.

In view of the above, it is desirable to provide OIL VCSEL optical transmission devices that optimize the ratio of optical carrier power to slave laser sideband power without changing the injection ratio of the devices.

### SUMMARY

One embodiment is an optical transmission device comprising a master laser configured to generate a master signal, a VCSEL configured for optical injection locking by the master laser, and an equalizer unit. The VCSEL is configured to generate a VCSEL output signal comprising a carrier component and a modulated sideband component. The equalizer unit is configured to receive the VCSEL output signal and output an equalized output signal having a reduced ratio of carrier component power to modulated sideband component power in comparison to the VCSEL output signal.

Another embodiment is an optical transmission device comprising a master laser configured to generate a master signal, a first VCSEL configured for optical injection locking by the master laser, a first three-port optical filter, a second VCSEL configured for optical injection locking by the master laser, and a second three-port optical filter. The first VCSEL is configured to generate a first VCSEL output signal comprising a first carrier component and a first modulated sideband component. The first three-port optical filter is configured to receive the first VCSEL output signal from the first VCSEL, separate the first carrier component and the first modulated sideband component, and separately transmit the first carrier component and the first modulated sideband component. The second VCSEL is configured to receive the first carrier component from the first three-port optical filter and generate a second VCSEL output signal comprising a second carrier component and a second modulated sideband component. The second three-port optical filter is configured to receive the second VCSEL output signal from the second VCSEL, separate the second carrier component and the second modulated sideband component, and separately transmit the second carrier component and the second modulated sideband component.

A further embodiment is an optical transmission method comprising injection locking a VCSEL by a master laser, operating the VCSEL to generate a VCSEL output signal comprising a carrier component and a modulated sideband component, transmitting the VCSEL output signal to an equalizer unit, forming an equalized output signal in the equalizer unit, and outputting the equalized output signal. The equalized output signal comprises a reduced ratio of carrier component power to modulated sideband component power in comparison to the VCSEL output signal.

A further embodiment is an optical transmission method comprising: injection locking a first VCSEL by a master laser; operating the first VCSEL to generate a first VCSEL output signal comprising a first carrier component and a first modulated sideband component; routing the first VCSEL output signal to a first three-port optical filter; separating the first carrier component and the first modulated sideband component with the first three-port optical filter; and separately transmitting the first carrier component and the first modulated sideband component with the first three-port optical filter. The method further comprises: injection locking a second VCSEL using the first carrier component; operating the second VCSEL to generate a second VCSEL output signal comprising a second carrier component and a second modulated sideband component; routing the second VCSEL output signal to a second three-port optical filter; separating the second carrier component and the second modulated sideband component with the second three-port optical filter; and separately transmitting the second carrier component and the second modulated sideband component from the second three-port optical filter.

The devices and methods disclosed herein enable higher optical link efficiency, higher spectral efficiency, higher bit rate, extended RoF links and longer wireless transmission distances in optical transmission systems. Additionally, the disclosed devices and methods provide relatively low cost ways to achieve the aforementioned attributes.

Additional features and advantages will be set forth in the detailed description which follows, and in part will be readily apparent to those skilled in the art from that description or recognized by practicing the embodiments as described herein, including the detailed description which follows, the claims, as well as the appended drawings.

It is to be understood that both the foregoing general description and the following detailed description are merely exemplary, and are intended to provide an overview or framework to understanding the nature and character of the claims. The drawings illustrate one or more embodiment(s), and together with the description serve to explain principles and operation of the various embodiments.

### BRIEF DESCRIPTION OF THE DRAWINGS

**FIG. 1** is a schematic representation of an optical transmission device according to one embodiment, including an optical circulator configured to route the output of a master laser to a slave laser and route the output of the slave laser to an optical transmission channel, and including an optical filter between the optical circulator and the optical transmission channel;

**FIG. 2** is a schematic representation of an optical transmission device according to another embodiment similar to the embodiment of **FIG. 1****,** but including an optical amplifier between the optical filter and the transmission channel;

**FIG. 3** is a schematic representation of an optical transmission device according to another embodiment, including two optical filters and a variable optical attenuator configured to provide a variable optical loss for the carrier component of an optical signal output by the device;

**FIG. 4** is a schematic representation of an optical transmission device according to another embodiment, including an optical filter configured to route the output of a master laser to a slave laser and route the output of the slave laser to an optical transmission channel;

**FIG. 5** is a schematic representation of an optical transmission device according to another embodiment similar to the embodiment of **FIG. 4** and including an optical isolator configured to protect the master laser from a reflected carrier component of the output from the master laser;

**FIG. 6** is a schematic representation of an optical transmission device according to another embodiment, in which the device is configured to injection lock a first slave laser and a second slave laser by reusing the optical carrier power emitted by a first optical filter as master power for the second slave laser;

**FIG. 7** is a schematic representation of an optical transmission device according to another embodiment, including two optical filters and an amplifier configured to amplify a sideband component of an optical signal output by a slave laser;

**FIG. 8** is a schematic representation of a conventional experimental OIL VCSEL setup;

**FIG. 9** shows frequency response plots for the experimental setup of **FIG. 8** with the VCSEL operating in free-running and OIL modes;

**FIG. 10** shows a plot of the optical spectra of the experimental setup of **FIG. 8** modulated with constant wavelength RF carriers at different frequencies;

**FIG. 11** shows the frequency response of an OIL-RoF link established by the experimental setup of **FIG. 8** for different fiber lengths;

**FIG. 12** shows curves of bit error rate (BER) versus received optical power for the experimental setup of **FIG. 8** operating in injection-locked mode with 2 Gbps amplitude shift key (ASK) baseband modulation on a 60.5 GHz carrier;

**FIG. 13** shows the optical spectrum of the experimental setup of **FIG. 8** modulated with a 2 Gbps ASK signal at 60.5 GHz;

**FIG. 14** is a schematic representation of a novel experimental OIL VCSEL setup configured to filter/equalize the output of an OIL VCSEL;

**FIG. 15** shows the optical spectrum of the experimental setup of **FIG. 14** modulated with a 2 Gbps ASK signal at 60.5 GHz;

**FIG. 16** shows frequency response plots of the experimental setup of **FIG. 14** with the VCSEL operating in free-running and OIL modes;

**FIG. 17** shows the electrical spectrum of a recovered baseband signal from the experimental setup of **FIG. 14**, employing direct modulation, after downconversion at a wireless receiver;

**FIG. 18** shows curves of BER versus received optical power for the experimental setups of FIG. 8 (without filtering/equalization) and **FIG. 14** (with filtering/equalization) modulated with a 2 Gbps ASK signal at 60.5 GHz;

**FIGS. 19** and **20** show curves of BER versus received optical power for the experimental setup of **FIG. 14** modulated with a 2 Gbps ASK signal at 60.5 GHz and a 3 Gbps ASK signal at 60.5 GHz, respectively.

**FIG. 21** shows eye diagrams of received ASK data before and after transmission over 20 km of standard single-mode fiber and 3 m wireless distance;

**FIG. 22** shows the electrical spectrum of a recovered RF signal from the experimental setup of **FIG. 14****,** employing 2 Gbps QPSK modulation at a sub-carrier frequency of 1.5 GHz;

**FIG. 23** shows signal-to-noise ratio (SNR) performance of the experimental setup of **FIG. 14****,** modulated with 2 Gbps QPSK data, after transmission over up-to 20 km of standard single-mode fiber and 3m wireless distance; and

**FIG. 24** shows constellation diagrams for the experimental setup of **FIG. 14****,** modulated with 2 Gbps QPSK data, after transmission over 20 km of standard single-mode fiber and 3m wireless distance.

### DETAILED DESCRIPTION

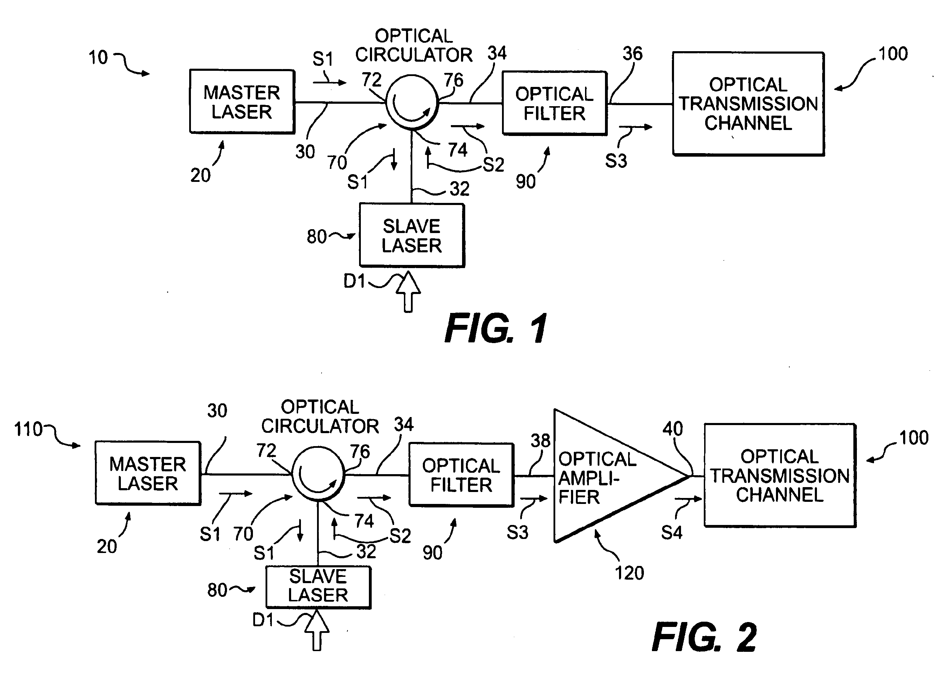

Reference will now be made in detail to the present preferred embodiments, examples of which are illustrated in the accompanying drawings. Whenever possible, the same reference numerals and characters will be used throughout the drawings to refer to the same or like parts. The disclosure is directed to optical transmission devices for radio-over-fiber (RoF) systems and particularly for multi-Gbps fiber-wireless systems operating at millimeter wave frequencies, such as 60 GHz. One embodiment of an optical transmission device is shown in **FIG. 1****,** and is designated generally throughout by the reference numeral **10.**

As shown in **FIG. 1**, the optical transmission device **10** includes a master laser **20**, an optical circulator **70** coupled to the master laser **20** by an optical link **30**, a slave laser **80** coupled to the optical circulator **70** by an optical link **32,** and a filter unit or equalizer unit **90** coupled to the optical circulator **70** by an optical link **34.** The filter unit/equalizer unit **90** is coupled to an optical transmission channel 100 by an optical link **36.** The optical links **30, 32, 34, 36** can be optical fibers or other optical connections such as, for example, optical waveguides or free-space optical connections.

The master laser **20** can be a high power, continuous-wave (CW) distributed feedback laser, for example. Suitable devices for the master laser **20** include, but are not limited to, EM4 model AA1401 manufactured by EM4 Incorporated. It should be understood, however, that other laser types and models can be used. The master laser **20** is configured to output a master optical signal **S1,** which includes an unmodulated optical carrier signal component.

The slave laser **80** can be, for example, a vertical cavity surface-emitting laser (VCSEL), such as a 1540 nm single mode buried tunnel junction (BTJ) VCSEL with a maximum power output of about 3 mW and 70% coupling efficiency to lensed fiber. The slave laser **80** is injection-locked by the master laser **20,** such that the slave laser **80** is configured to output an optical signal **S2** that is locked in frequency and phase to the carrier signal **S1** of the master laser **20.** The slave laser **80** is modulated such that the signal **S2** is a modulated signal having a carrier signal component and a single sideband signal component. The slave laser **80** can be modulated by a data stream **D1,** which can include amplitude shift key (ASK) modulated data, quadrature phase key modulated data (QPSK), or orthogonal frequency division multiplexing (OFDM), for example. Other modulation formats are possible, as well.

The optical circulator **70** includes a first port **72** in optical communication with the master laser **20** via the optical link **30,** a second port **74** in optical communication with the slave laser **80** via the optical link **32** and a third port **76** in optical communication with the filter unit/equalizer unit **90** via the optical link **34.** As illustrated in **FIG. 1****,** the optical circulator **70** is configured to route the signal **S1** of the master laser **20** to the slave laser **80** and to route the output signal **S2** of the slave laser **80** to the filter unit/equalizer unit **90**. The optical circulator **70** can be a three-port optical circulator, such as JDSU model CIR-330011000 manufactured by JDS Uniphase Corporation, for example.

The filter unit/equalizer unit **90** can be an optical bandpass filter having a wavelength dependent transmission. Examples of suitable bandpass filters are JDSU models TB9226 or MTBF-A1CS0 manufactured by JDS Uniphase Corporation, however other bandpass filters can be used. The bandpass filter **90** is configured to attenuate the carrier signal component and transmit an equalized output signal **S3** to the optical transmission channel **100.** In other words, the filter **90** is configured such that the wavelength of the sideband signal component is located in the passband of the filter **90.** The output signal **S3** includes an attenuated carrier signal component (high insertion loss through the filter **90**) and a less attenuated or substantially unattenuated sideband signal component (minimal insertion loss through the filter **90**)**.** The output signal **S3** is said to be an "equalized" signal because the ratio of optical power of the carrier signal component to optical power of the sideband signal component in signal **S3** is reduced in comparison to the signal **S2** output by the slave laser **80.** Generally speaking, it is desirable for the ratio of the carrier signal component power to the sideband signal component power in the signal **S3** to be close to 0 dB (i.e., roughly equal power in the carrier and sideband signal components), and the filter **90** can be tuned accordingly. One method of tuning the filter **90** is to place the carrier signal component of the signal **S2** on one of the edges of the response curve of the filter **90,** and then adjust the power of the carrier signal component upwards or downwards by tuning the center frequency of the filter **90** on the left or right. If the transmission characteristics of the filter **90** are roughly uniform over its passband, then the power of the modulated sideband will remain constant during filter tuning.

In operation of the device **10,** the master laser **10** generates the master signal **S1,** which is routed through the optical circulator **70** to the slave laser **80.** The slave laser **80** is injection-locked by the master laser **20**, and as a result outputs the modulated signal **S2** including the carrier signal component from the master laser **20** and a modulation sideband signal component. The signal **S2** is routed through the optical circulator **70** to the filter unit/equalizer unit **90.** The filter unit/equalizer unit **90** attenuates the carrier signal component to a greater degree than it attenuates the modulation sideband signal component or, alternatively, attenuates the carrier signal component while passing the modulation sideband signal component substantially unattenuated to form the equalized output signal **S3.** The output signal **S3,** including the attenuated carrier component and the less attenuated/substantially unattenuated sideband signal component, is transmitted to the optical transmission channel **100.**

Although the filter unit/equalizer unit **90** is described as being a bandpass filter, it should be understood that other types of filters such as low-pass filters and band-stop filters (e.g. fiber bragg grating filters (FBG)) can be used.

Another embodiment of an optical transmission device is shown in **FIG. 2****,** and is designated by the reference numeral **110.** The device **110** is similar to the device **10** of **FIG. 1****,** with exception that, instead of the filter unit/equalizer unit **90** being coupled directly to the optical transmission channel **100,** the device **110** includes an optical amplifier **120** coupled to the filter unit/equalizer unit **90** by an optical link **38** and coupled to the optical transmission channel **100** by an optical link **40.** The optical links **38, 40** can be optical fibers or other optical connections such as, for example, optical waveguides or free-space optical connections.

The optical amplifier **120** can be an Erbium-doped waveguide amplifier (EDFA), for example, such as Oclaro models PureGain PG1000 or PureGain PG1600 manufactured by Oclaro, Incorporated. However, other types of amplifiers can be used. The optical amplifier **120** is configured to amplify the equalized output signal **S3** from the filter unit/equalizer unit **90** and transmit an amplified, equalized output signal **S4** to the optical transmission channel **100.** By transmitting the amplified, equalized output signal **S4,** the device **110** provides increased signal-to-noise (SNR) ratios and enables a longer fiber and wireless transmission range, use of signal modulation formats with higher spectral efficiency (e.g. QPSK) leading to higher bit rates in comparison to the embodiment of **FIG. 1****.**

According to a variation of the embodiment of **FIG. 2**, the optical amplifier **120** can be configured to provide higher optical gain to the sideband signal component of the signal **S3** than the optical gain provided to the carrier signal component of the signal **S3.** For example, the optical amplifier **120** can include a component that provides wavelength-dependent optical gain or wavelength-dependent optical loss. In such a variation, the optical amplifier **120** also performs the function of an optical filter, and the filter unit/equalizer unit **90** can therefore be eliminated.

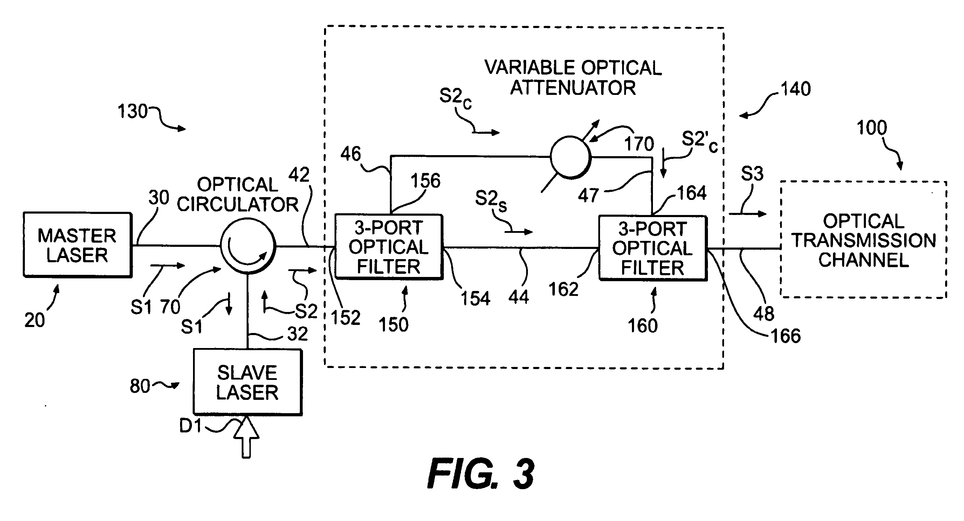

Another embodiment of an optical transmission device is shown in **FIG. 3****,** and is designated by the reference numeral **130.** The device **130** is similar to the device **10** of **FIG. 1****,** except that the device **130** includes a filter unit/equalizer unit **140** instead of the filter unit/equalizer unit **90.** The filter unit/equalizer unit **140** is coupled to the optical circulator **70** by an optical link **42** and coupled to the optical transmission channel **100** by an optical link **48.** The filter unit/equalizer unit **140** includes a first three-port optical filter **150,** a second three-port optical filter **160** and a variable optical attenuator **170.** The three-port optical filters **150, 160** can be JDSU model DWS-1Fxxx3L20 manufactured by JDS Uniphase Corporation, for example. The variable optical attenuator **170** can be JDSU MVOA-A2SS0-M100-MFA manufactured by JDS Uniphase Corporation, for example. However, other types of filters and attenuators can be used.

The first three-port optical filter **150** includes a first port **152** coupled to the optical circulator **70** by the optical link **42,** a second port **154** coupled to the second three-port optical filter **160** by the optical link **44,** and a third port **156** coupled to the variable optical attenuator **170** by an optical link **46.** The second three-port optical filter **160** includes a first port **162** coupled to the second port **154** of the first three-port optical filter **150** by the optical link **44,** a second port **164** coupled to the variable optical attenuator **170** by an optical link **47,** and a third port **166** coupled to the optical transmission channel **100** by the optical link **48.** The optical links **42, 44, 46, 47, 48** can be optical fibers or other optical connections such as, for example, optical waveguides or free-space optical connections.

The first three-port optical filter **150** is configured to receive the signal **S2** from the slave laser **80** through the first port **152** and separate the sideband signal component **S2ₛ** and the carrier signal component **S2_{c}** of the signal **S2** from each other based on the difference in wavelength between the sideband signal component **S2ₛ** and the carrier signal component **S2_{c}**. The first three-port optical filter **150** is configured to output the sideband signal component **S2ₛ** and the carrier signal component **S2_{c}** from its second and third ports **154, 156,** respectively, with minimal attenuation of the components **S2ₛ, S2_{c}.** The variable optical attenuator **170** is configured to attenuate the carrier signal component **S2_{c}** to form an attenuated carrier signal component **S2_{c}'** and output the attenuated carrier signal component **S2_{c}'.** The second three-port optical filter **160** is configured to receive the sideband signal component **S2ₛ** and the attenuated carrier signal component **S2_{c}'** through the first and second ports **162, 164,** respectively, and combine the sideband signal component **S2ₛ** and the carrier signal component into a single, equalized output signal **S3.** The second three-port optical filter **160** is configured to output the signal S3 through the third port **166** to the optical link **48.**

In operation of the device **130**, the first optical filter **150** receives the signal **S2** and filters the signal **S2** such that the sideband signal component **S2ₛ** and the carrier signal component **S2_{c}** are separated from each other in the filter **150** with little or no attenuation of both components **S2ₛ**, **S2_{c}**. The first optical filter **150** then outputs the sideband signal component **S2ₛ** to the second three-port optical filter **160** and outputs the carrier signal component **S2_{c}** to the variable optical attenuator **170.** The variable optical attenuator **170** then attenuates the carrier signal component **S2_{c}** to form the attenuated carrier signal component **S2_{c}'** and outputs the attenuated carrier signal component **S2_{c}'** to the second three-port optical filter **160.** The second three-port optical filter **160** then combines the sideband signal component **S2ₛ** and the attenuated carrier signal component **S2_{c}'** to form the equalized output signal **S3** and outputs the signal **S3** to the optical transmission channel **100** via the optical link **48**. The amount of attenuation carried out by the variable optical attenuator **170** can be varied based on the desired ratio of carrier signal component power to sideband signal component power in the signal **S3.**

According to a variation of the embodiment of **FIG. 3****,** the second three-port optical filter **160** can be replaced with a three-port optical power coupler configured to receive the sideband signal component **S2ₛ** and the attenuated carrier signal component **S2_{c}'** from the first three-port optical filter **150** and the variable optical attenuator **170**, respectively, and combine the sideband signal component **S2ₛ** and the attenuated carrier signal component **S2_{c}'** to form the equalized output signal **S3.** An example of a suitable three-port optical power coupler is JDSU model FFCHCKS1AB100 manufactured by JDS Uniphase Corporation, for example.

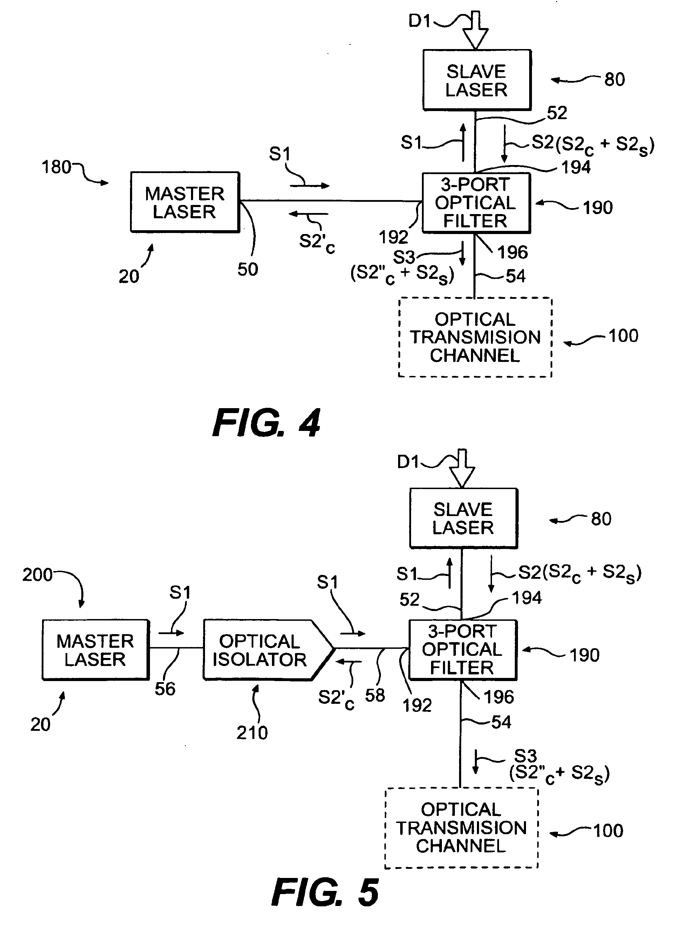

Another embodiment of an optical transmission device is shown in **FIG. 4****,** and is designated by the reference numeral **180.** The device **180** includes a master laser **20,** a filter unit/equalizer unit **190** coupled to the master laser **20** by an optical link **50,** and a slave laser **80** coupled to the filter unit/equalizer unit **190** by an optical link **52.** The filter unit/equalizer unit **190** is coupled to an optical transmission channel **100** by an optical link **54.** The optical links **50, 52, 54** can be optical fibers or other optical connections such as, for example, optical waveguides or free-space optical connections.

The filter unit/equalizer unit **190** can be a three-port optical filter having a first port **192** coupled to the master laser **20** by the optical link **50,** a second port **194** coupled to the slave laser **80** by the optical link **52,** and a third port **196** coupled to the optical transmission channel **100** by the link **54.** The three-port optical filter **190** can be an interference filter, such as JDSU model DWS-1Fxxx3L20 manufactured by JDS Uniphase Corporation, for example.

As in the previous embodiments, the master laser **20** is configured to output a signal **S1** including a carrier signal component. The three-port optical filter **190** is configured such that light of the wavelength of the signal **S1** can pass from the first port **192** to the second port **194** with low loss (insubstantial attenuation), and is therefore configured to route the signal **S1** to the slave laser **80** with low loss. The slave laser **80** can therefore be injection-locked by the master laser **20,** such that slave laser **80** is configured to output an optical signal **S2** having a carrier signal component **S2_{c}** and a single sideband signal component **S2ₛ.** The three-port optical filter **190** is configured such that the sideband signal component of the signal **S2ₛ** can pass from the second port **194** to the third port **196** with low loss, and the carrier signal component **S2_{c}** can pass from the second port **194** to the third port **196** with high loss (at least partial attenuation) such that a large portion of the carrier signal component **S2_{c}'** is reflected towards the master laser **20.** Thus, the three-port optical filter **190** is configured to output an equalized output signal **S3** to the optical transmission channel **100** through the optical link **54** including the sideband signal component **S2ₛ** of the signal **S2** and a partially attenuated carrier signal component **S2_{c}"** derived from the signal **S2.**

In operation of the device **180,** the master laser **20** outputs the signal **S1** to the three-port optical filter **190.** The three-port optical filter **190** then routes the signal **S1** to the slave laser **80,** which, in response, outputs the signal **S2** to the three-port optical filter **190.** The three-port optical filter **190** then reflects the portion **S2_{c}'** of the carrier signal component towards the master laser **20** through the first port **192** and outputs the equalized output signal **S3,** including the sideband signal component **S2ₛ** and the partially attenuated carrier signal component **S2_{c}",** through the third port **196.** Thus, it can be appreciated that the three-port optical filter **190** performs the functions of routing the signals **S1, S2** and filtering the signal **S2.**

According to a variation of the embodiment of **FIG. 4****,** the three-port optical filter **190** can be configured to absorb, rather than reflect, the portion **S2_{c}'** of the carrier signal component **S2_{c}.**

Another embodiment of an optical transmission device is shown in **FIG. 5****,** and is designated by the reference numeral **200.** The device **200** is similar to the device **180** of **FIG. 4****,** except that the device **200** includes an optical isolator **210** disposed in the pathway between the master laser **20** and the three-port optical filter **190** to protect the master laser **20** from the reflected portion of the carrier signal component **S2_{c}'**. Specifically, the optical isolator **210** can be coupled to the master laser **20** by an optical link **56** and coupled to the first port **192** of the three-port optical filter **190** by an optical link **58.** The optical links **56, 58** can be optical fibers or other optical connections such as, for example, optical waveguides or free-space optical connections. Alternatively, the optical isolator **210** can be integrally formed with the master laser **20.**

The optical isolator **210** is configured to absorb the backward travelling carrier signal component **S2_{c}** to prevent the reflected portion of the carrier signal component **S2_{c}'** from interfering with the operation of the master laser **20** or even damaging it. The optical isolator **210** can be Photop model KISO-S-A-250S-1550-NN manufactured by Photop Technologies, Incorporated, for example.

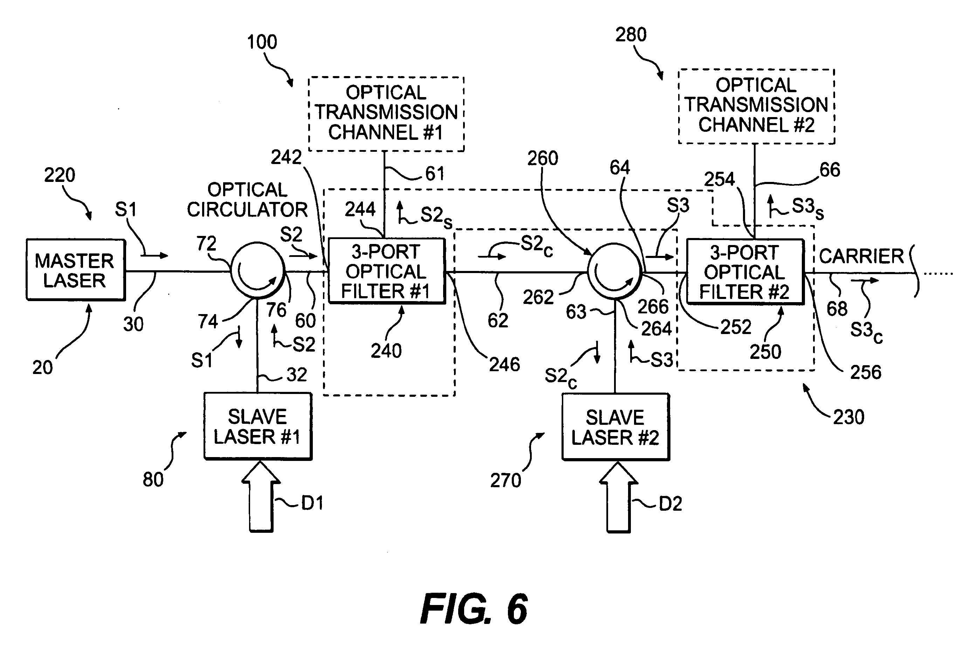

Another embodiment of an optical transmission device is shown in **FIG. 6**, and is designated by the reference numeral **220.** The optical transmission device **220,** similarly to the embodiment of **FIG. 1****,** includes a master laser **20,** an optical circulator **70** coupled to the master laser **20** by an optical link **30,** and a first slave laser **80** coupled to the optical circulator **70** by an optical link **32.** The device **220** includes a filter unit/equalizer unit **230** coupled to the first optical circulator **70** by an optical link **60,** a second optical circulator **260** including a first port **262,** a second port **264** and a third port **266,** and coupled to the filter unit/equalizer unit **230** by optical links **62, 64,** and a second slave laser **270** coupled to the second optical circulator **260** by an optical link **63.** The filter unit/equalizer unit **230** is coupled to a first optical transmission channel **100** by an optical link **61** and a second optical transmission channel **280** by an optical link **66.** The optical links **60, 61, 62, 63, 64, 66** can be optical fibers or other optical connections such as, for example, optical waveguides or free-space optical connections.

The filter unit/equalizer unit **230** includes a first three-port optical filter **240** having a first port **242** coupled to the third port **76** of the first optical circulator **70** by the optical link **60,** a second port **244** coupled to the first optical transmission channel **100** by the optical link **61,** and a third port **246** coupled to the first port **262** of the second optical circulator **260** by the optical link **62.** The filter unit/equalizer unit **230** also includes a second three-port optical filter **250** having a first port **252** coupled to the third port **266** of the second optical circulator, a second port **254** coupled to the second optical transmission channel **280** by the optical link **66** and a third port **256** optionally connected to an additional device or component, such as another filter or circulator (not shown). The three-port optical filters **240, 250** are similar to the three-port optical filter **150** employed in the embodiment of **FIG. 3****.**

The master laser **20** is configured to output a master optical signal **S1** and the first slave laser **80** can be injection-locked by the master laser **20,** such that the first slave laser **80** is configured to output an optical signal **S2.** The slave laser **80** is modulated by a first data stream **D1** such that the signal **S2** has a carrier signal component **S2_{c}** and a single sideband signal component **S2ₛ** including data from the first data stream **D1**. The first data stream **D1** can include ASK modulated data, QPSK modulated data, or OFDM modulated data, for example.

The first three-port optical filter **240** is configured to receive the signal **S2** from the first slave laser **80** through the first port **242** and separate the sideband signal component **S2ₛ** and the carrier signal component **S2_{c}** of the signal **S2** from each other based on the difference in wavelength between the sideband signal component **S2ₛ** and the carrier signal component **S2_{c}.** The first three-port optical filter **240** is configured to output the sideband signal component **S2ₛ** and the carrier signal component **S2_{c}** from its second and third ports **244, 246,** respectively, with minimal attenuation of the components **S2ₛ, S2_{c}.** The sideband signal component **S2ₛ** is transmitted to the first optical transmission channel **100** through the optical link **61.**

The second optical circulator **260** is configured to route the carrier signal component **S2_{c}** to the second slave laser **270,** and the second slave laser **270** therefore can also be injection-locked by the master laser **20.** The second slave laser 270 is modulated by a data by a second data stream **D2** such that the second slave laser **270** outputs a signal **S3** having a carrier signal component **S3_{c}** and a single sideband signal component **S3ₛ** including data from the second data stream **D2.** The second data stream **D2** can include ASK modulated data, QPSK modulated data, or OFDM modulated data, for example.

The second optical circulator **260** is configured to route the signal **S3** to the second three-port optical filter **250.** The second three-port optical filter **250** is configured to receive the signal **S3** from the second slave laser **270** through the first port **252** and separate the sideband signal component **S3ₛ** and the carrier signal component **S3_{c}** of the signal **S2** from each other based on the difference in wavelength between the sideband signal component **S3ₛ** and the carrier signal component **S3_{c}.** The second three-port optical filter **250** is configured to output the sideband signal component **S3ₛ** and the carrier signal component **S3_{c}** from its second and third ports **254, 256,** respectively, with minimal attenuation of the components **S3ₛ, S3_{c}.** The sideband signal component **S3ₛ** is transmitted to the second optical transmission channel **280** through the optical link **66.** The carrier signal component **S3_{c}** can optionally be transmitted to further components or devices (not shown) through the optical link **68.**

In operation, the master laser **20** outputs the signal **S1,** which is routed through the first optical circulator **70** to the first slave laser **80.** In response to the signal **S1,** the first slave laser **80** outputs the signal **S2,** which is routed through the first optical circulator 70 to the first three-port optical filter **240.** The first three-port optical filter **240** separates the sideband signal component **S2ₛ** and the carrier signal component **S2_{c}** of the signal **S2** from each other based on the difference in wavelength between the sideband signal component **S2ₛ** and the carrier signal component **S2_{c},** and outputs the sideband signal component **S2ₛ** and the carrier signal component **S2_{c}** from its second and third ports **244, 246,** respectively. There is minimal attenuation of the components **S2ₛ, S2_{c}** in the filter **240.** The sideband signal component **S2ₛ** is transmitted to the first optical transmission channel **100** through the optical link **61,** and the carrier signal component **S2_{c}** is transmitted to the second optical circulator **260.** The second optical circulator **260** routes the carrier signal component **S2_{c}** to the second slave laser **270,** and the second slave laser **270** is thereby injection-locked by the master laser **20.** In response to the carrier signal component **S2_{c},** the second slave laser **270** outputs the signal **S3.** The second optical circulator **260** routes the signal **S3** from the second slave laser **270** to the second three-port optical filter **250,** which separates the sideband signal component **S3ₛ** and the carrier signal component **S3_{c}** of the signal **S3** from each other based on the difference in wavelength between the sideband signal component **S3ₛ** and the carrier signal component **S3_{c}.** The second three-port optical filter **250** then outputs the sideband signal component **S3ₛ** and the carrier signal component **S3_{c}** from its second and third ports **254, 256,** respectively. There is minimal attenuation of the components **S3ₛ, S3_{c}** in the filter **250.** The sideband signal component **S3ₛ** is transmitted to the second optical transmission channel **280** through the optical link **66,** and the carrier signal component **S2_{c}** is optionally transmitted to other components or devices through the optical link **68.**

It can be appreciated that the embodiment of **FIG. 6** enables multiple slave lasers to be injection-locked by a single master laser and makes use of optical power that would otherwise be wasted. Specifically, the optical carrier power emitted by the first slave laser **80** is used as maser power for the second slave laser **270.** Unlike conventional devices which include two slave lasers injection-locked by a master laser through a splitter, the power of the master laser **20** in the embodiment of **FIG. 6** does not need to be two times the power necessary to injection-lock a single slave laser.

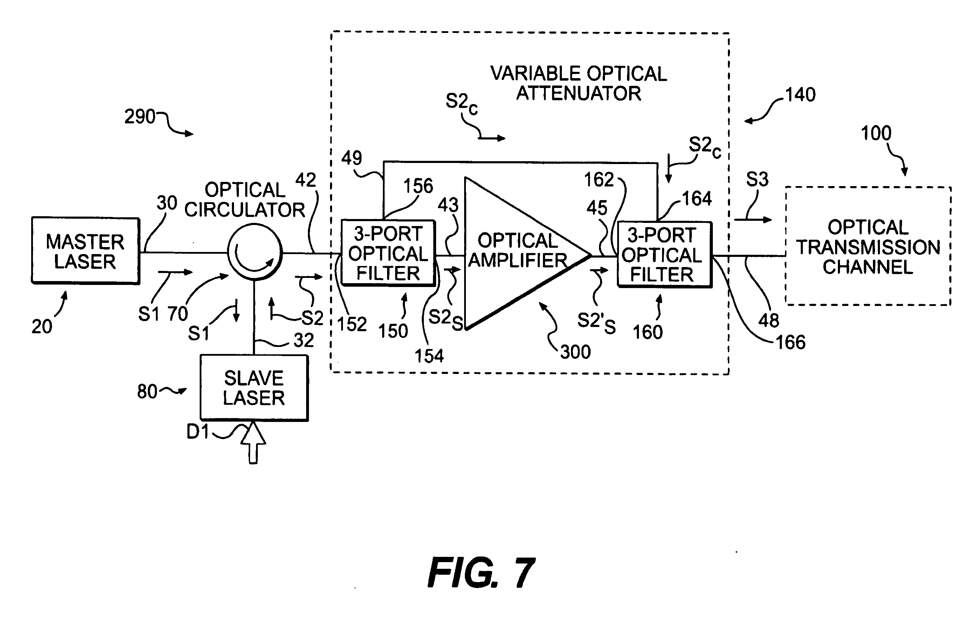

Another embodiment of an optical transmission device is shown in **FIG. 7****,** and is designated by the reference numeral **290.** The device **290** is similar to the device **130** of **FIG. 3****,** with the exception that a variable gain optical amplifier **300** is located between the first and second three-port optical filters **150, 160,** and the variable optical attenuator **170** is eliminated. An example of a suitable variable gain optical amplifier is Oclaro model PureGain PG2800 manufactured by Oclaro Incorporated, for example. Specifically, in this embodiment, the optical amplifier **300** is coupled to the second port **154** of the first three-port optical filter **150** by an optical link **43** (e.g., optical fiber, optical waveguide or free-space connection) and is coupled to the first port **162** of the second three-port optical filter **160** by an optical link **45** (e.g., optical fiber, optical waveguide or free-space connection). The third port **156** of the first three-port optical filter **150** is coupled to the second port **164** of the second three-port optical filter or optical power coupler **160** by an optical link **49** (e.g., optical fiber, optical waveguide or free-space connection).

The optical amplifier **300** is configured to amplify the sideband signal component **S2ₛ** to form an amplified sideband signal component **S2ₛ'** and output the amplified sideband signal component **S2ₛ'** to the second three-port optical filter **160.** The amount of amplification can be adjusted as desired. The first three-port optical filter **150** is configured to output the carrier signal component **S2_{c}** to the second three-port optical filter **160.** The second three-port optical filter or optical power coupler **160** is configured to combine the amplified sideband signal component **S2ₛ'** and the carrier signal component **S2_{c}** to form an equalized output signal **S3,** and output the signal **S3** to the optical transmission channel **100.** Thus, the device **290** provides another way to use three-port optical filters to separate, equalize and recombine carrier and sideband signal components in an optical signal.

Various embodiments will be further clarified by the following examples.

### EXAMPLES

### Example 1. (Conventional Transmitter without Equalization of VCSEL Output)

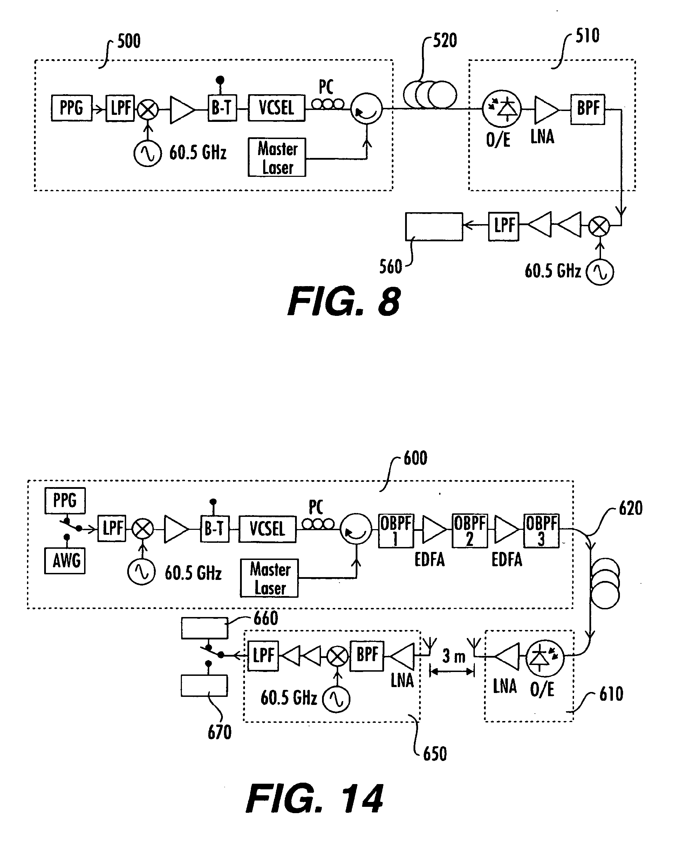

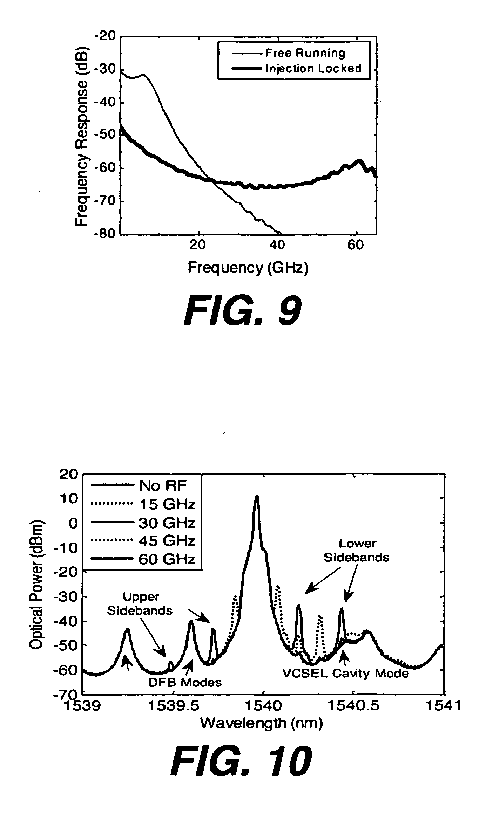

An experimental setup of a conventional OIL VCSEL RoF transmission system was constructed as shown in **FIG. 8****.** In this setup, a Head-End Unit or HEU **500** was coupled to a remote antenna unit or RAU **510** by optical fiber **520.** The HEU **500** consisted of a pulse pattern generator PPG, a low pass filter LPF, a bias T B-T, a slave VCSEL, a high-power Master Laser, and a custom-made one-step 60 GHz electrical up-converter. The remote antenna unit **510** included an optical-to electrical converter O/E, a low noise amplifier LNA, and a bandpass filter BPF. The signal from the remote antenna unit **510** was down-converted to baseband by a one-step 60 GHz down-converter, and fed into a bit error rate tester (BERT) **560.** The VCSEL was a 1540 nm single-mode buried tunnel junction (BTJ) VCSEL with a maximum output power of ∼ 3mW, and ∼ 70% coupling efficiency to a lensed fiber. The ML was a high-power Distributed Feedback (DFB) laser, which was operated in continuous wave (CW) mode. The VCSEL was injection locked by coupling a 40.7 mW optical signal from the high-power ML into the VCSEL via the circulator as shown. A polarization controller was used to maximize the injection ratio efficiency by matching the ML polarization to that of the VCSEL. The bias current of the VCSEL emitting ∼ I mW optical power was set at 4.7 mA. The ML was biased at 218.9 mA with an output power of 40.7mW in order to achieve an optimized (flat) frequency response at 61 GHz as shown in **FIG. 9****,** which illustrates VCSEL modulation bandwidth enhancement through optical injection locking.

To investigate the characteristics of SSB modulation under different signal frequencies, an un-modulated (CW) RF signal was applied to the VCSEL under OIL. The signal frequency was varied from 5 GHz to 65 GHz and the modulated optical signal observed on an Optical Spectrum Analyzer (OSA). **FIG**. **10** shows the optical spectra from the OIL transmitter modulated with single-tone (unmodulated) RF carriers at selected RF frequencies observed with the OSA resolution set to 0.02 nm. It can be seen that at lower modulation frequencies the two modulation sidebands were closer in intensity than at higher frequencies. For instance, at 15 GHz the power difference between the Upper Sideband (USB) and the Lower Sideband (LSB) was only 4.3 dB. This power difference grew to 10.7 at the RF modulation frequency of 30 GHz. At 60 GHz the power difference was even larger at 21.4 dB - with the LSB experiencing a significant amplification being near to the VCSEL cavity mode, and the USB being attenuated as shown.

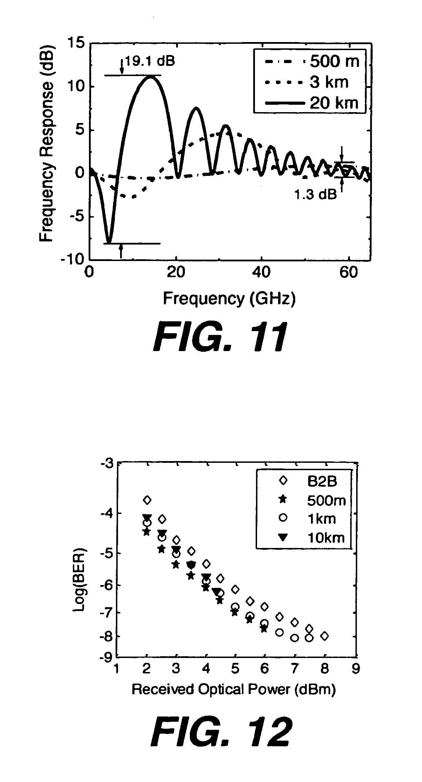

To examine the impact of fiber chromatic dispersion on RF signal fading, the transfer function of standard single-mode fiber at various lengths was measured with a Lightwave Component Analyzer. The fiber launch power was kept constant at +5.2 dBm in all cases, to ensure that Stimulated Brillioun Scattering (SBS) did not impact the results. The results are shown in **FIG. 11****,** where the responses of various fiber lengths are normalized to the Back-to-Back (B2B) frequency response. Much larger signal amplitude swings were observed at lower frequencies than at higher frequencies. For instance, with the 20 km fiber transmission, the signal amplitude swing was 19.1 dB between 5 and 18 GHz, while it was just 1.3 dB around 60 GHz. The signal amplitude swings were caused by interfering modulation sidebands due to their relative phase variations caused by fiber's chromatic dispersion. This result implies that dispersion-induced fading in an intensity-modulation direct-detection (IMDD) RoF system employing an OIL-VCSEL is strongly frequency-dependent. Since chromatic dispersion is essentially constant over the RF frequencies considered, the reduced signal fading observed at 60 GHz is due to strong SSB modulation. This result is consistent with the result in **FIG. 10****,** which shows that the modulated signal of an OIL VCSEL is essentially DSB at low frequencies becoming SSB only at higher (mm-wave) frequencies. This is an important bonus of using OIL for transmitting mm-wave signals since they are in fact more severely impacted by chromatic-dispersion induced signal fading than low-frequency signals.

The positive frequency response at lower frequencies observed in **FIG. 11** is due to frequency modulation to intensity modulation (FM-IM) conversion of the chirp of the OIL VCSEL over the dispersive fiber.

### IMDD RoF System at 60 GHz with Inherent Dispersion Tolerance

Using a simple one-step electrical up-converter, Pseudo Random Binary Sequence (PRBS) data at baseband was up-converted directly to a center frequency of 60.5 GHz in a single step. The PRBS pattern length was 2³¹-1. To further simplify the RoF system, both sidebands of the up-converted signal were returned for transmission. Therefore, the transmitted 60.5 GHz signal was DSB-modulated with the occupied 3dB bandwidth of ∼ 4 GHz for the baseband data-rate of 2 Gbps.

The up-converted signal was amplified by a power amplifier (22 dB) to an average RF power of +0.5 dBm and fed into the VCSEL via a bias-T, resulting in direct intensity modulation of the VCSEL's optical signal at 60.5 GHz. The intensity-modulated optical signal was then transmitted over standard single-mode optical fibers of various lengths to the Remote Antenna Unit (RAU). Fiber launch power was set to +10 dBm.

At the RAU the transmitted optical signal was detected by a 70 GHz photodiode resulting in the generation of an ASK-modulated mm-wave signal at 60.5 GHz. The generated signal was amplified by a Low Noise Amplifier (LNA) with a gain of about 38 dB. After filtering in a 7 GHz BPF, the 60.5 GHz mm-wave signal was down-converted directly to baseband. Two cascaded low-frequency power amplifiers (24 dB + 19 dB) amplified the recovered signal prior to analysis by the Error Detector (ED).

The measured BER for fiber spans of 0km (B2B), 500m, 1km, and 10km is shown in **FIG. 12****.** It was observed that there was no significant difference in the system sensitivity for all fiber spans tested. For instance, at a BER of 1 x 10⁻⁵, the difference in optical power sensitivities for all the fiber spans was less than 0.5 dB. In a DSB-modulated RoF system, severe signal fading occurs at 60.5 GHz after 1km fiber transmission. This results in serious ISI, a severely distorted eye diagram, and a very high BER. Therefore, this result shows that the 60 GHz RoF system employing an OIL-VCSEL for 2 Gbps ASK data modulation over single-mode fibers (various lengths) did not suffer the severe fiber chromatic dispersion-induced fading that limits the maximum fiber transmission distance of DSB-modulated systems to less than 1km. This is attributed to the inherent strong SSB modulation present in OIL transmitters, as discussed above.

**FIG. 12** reveals non-linearity in the RoF system at higher received optical powers exceeding +4 dBm leading to error flooring near the BER of 1 x 10⁻⁸. However, since the measured BER values are well below the FEC threshold, error free transmission is possible with FEC. Alternatively, simple linear Feed-Forward Equalization (FFE) may be applied to the recovered baseband signal to reverse ISI effects and achieve error free transmission.

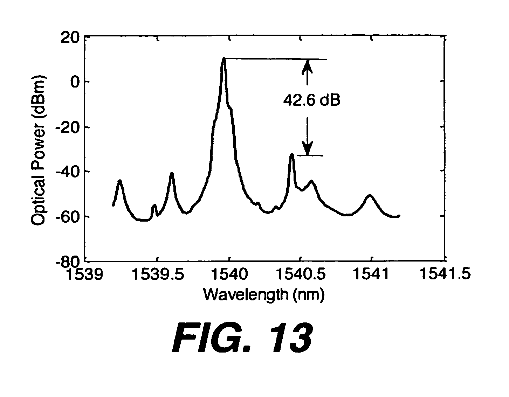

One important observation from **FIG. 12** is that the sensitivity of the RoF system was very poor. The system required > 0 dBm received optical power to meet the FEC threshold (1 x 10⁻³). This can be explained by considering the optical spectrum of the transmitted optical signal, shown in **FIG. 13. FIG. 13** illustrates the optical spectrum of the transmitted OIL RoF system signal after direct VCSEL modulation with a 2 Gbps ASK signal at 60.5 GHz. From the optical spectrum, it is clear that the poor system sensitivity is due to the extremely high Carrier-to-Sideband power ratio (CSR). The difference in peak carrier optical power at about 1540 nm and peak sideband optical power at about 1540.5 nm is shown as 42.6 dB. The high CSR is caused by the large ML power, which is required for OIL, and is transmitted together with the VCSEL's modulated optical signal. Because of the poor sensitivity of the system, the maximum fiber transmission distances of this RoF system is limited by the SBS threshold, which limits the maximum fiber launch power at the HEU, and the fiber loss, which limits the received power. With this system, 10 km fiber transmission was achieved by limiting the launch optical power +10 dBm to avoid SBS.

### Example 2. (Transmitter with Bandpass Filtering/Equalization of VCSEL Output)

### Experimental Setup

To improve the sensitivity of the RoF system of Example 1 above, it was necessary to reduce the large CSR observed above. Thus, the experimental setup of **FIG. 14** was constructed. The setup is generally arranged as a Head-End Unit **600** connected to a remote antenna unit 610 by optical fiber **620,** which communicates with a 60 GHz wireless receiver **650.** The arrangement included a pulse pattern generator PPG, arbitrary waveform generator AWG, low pass filter LPF, bias T B-T, band pass filter BPF, optical bandpass filters OBPF 1, OBPF 2 and OBPF 3, erbium doped fiber amplifiers EDFA, bit error rate tester (BERT) **660,** and vector signal analyzer (VSA) **670.** In this setup, a tunable filter was used to reduce the master carrier power. Given that the large CSR observed above was similar in value to the contrast ratio of typical tunable optical filters, placing the passband of a single optical bandpass filter (OBPF) (BW = 0.25 nm) around the modulation sideband wavelength (so that the ML wavelength was outside the filter's passband) was sufficient to equalize the CSR. The filter bandwidth requirements were significantly relaxed by the sizeable frequency separation (0.5 nm) between the ML wavelength and the VCSEL sideband due to the high frequency of the 60 GHz carrier used. An EDFA preamp and a booster EDFA were then used to boost the equalized optical signal, followed by ASE noise filtering (0.6 nm, and 3 nm), as shown in **FIG. 14****.** To realize wireless signal transmission, the signal exiting the LNA at the RAU was fed into a standard gain horn antenna (gain = 23 dBi) and radiated into the air. After wireless transmission over 3 m, the signal was received by a 60 GHz wireless receiver using another standard gain horn antenna. The received signal was then amplified by a LNA (gain = 22 dB), and filtered by a band pass filter (BPF; center frequency = 60.5 GHz, bandwidth = 7 GHz) before being down-converted to baseband, as shown in **FIG. 14****.**

### Impact of Equalization Filter

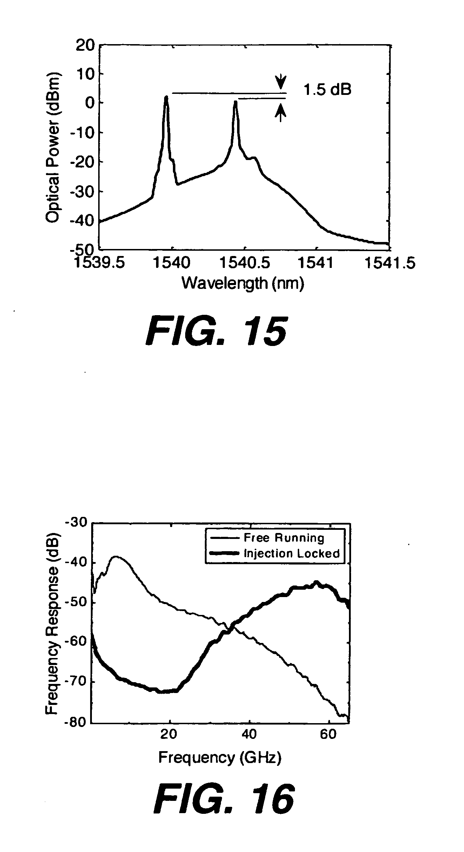

The impact of the equalization filter in the setup of **FIG. 14** is shown in **FIG. 15. FIG. 15** illustrates the optical spectrum of the carrier-sideband power ratio equalized signal with the OIL VCSEL modulated directly with a 2 Gbps ASK signal at 60.5 GHz. As shown in **FIG. 15****,** the difference in the peak optical power between the master carrier at just below 1539.5 nm and the VCSEL's modulated sideband peak optical power at just below 1540 nm was reduced dramatically from 42.6 dB (shown in **FIG. 13**) to 1.5 dB. Although the accurate definition of CSR is the ratio between the optical carrier and modulated sideband powers calculated in a specified bandwidth rather than the simple ratio between the peak powers, it is obvious from **FIG. 15** that the CSR was significantly closer to optimal (∼0 dB for single carrier modulation) than it was without filtering. The frequency response of the equalized OIL-VCSEL with the same ML and VCSEL biasing conditions as those used to obtain **FIG. 9** is shown in **FIG. 16. FIG. 16** illustrates the frequency response of the carrier-to-sideband power ratio in an equalized RoF system employing direct modulation of OIL VCSEL. It can be seen that, compared to the un-equalized system, the frequency response was now heavily tilted in favor of the higher frequencies. Unlike in the un-equalized case, the response around the 60 GHz band was now much higher than at the lower frequencies below 30 GHz. This was due to the narrow-band optical BPF used, which tended to attenuate modulation sidebands at the lower modulation frequencies, since the filter's passband was tuned to the centre wavelength of the VCSEL's modulated sideband (i.e. optimized for 60 GHz modulation signals). **FIG. 16** also shows that the equalized system had a relatively flat response (within 3 dB) over a wide frequency band equal to 18 GHz.

**FIG. 16** also shows that the new frequency response at 60 GHz was now within 5 dBs of the frequency response of the free running VCSEL - signifying approximately 13 dB improvement in the response of the equalized system. This was a result of the post-CSR equalization amplification, which was only made possible by the CSR equalization. Apart from improving the system sensitivity, the higher frequency response also provided the critical system power budget, which was needed to overcome the high pathloss at 60 GHz in order to realize successful wireless signal transmission. The significantly improved frequency response also resulted in a higher received signal SNR, making it possible to use more spectrally efficient modulation formats such as QPSK, which require a higher SNR than ASK modulation.

### Results for ASK Data Modulation

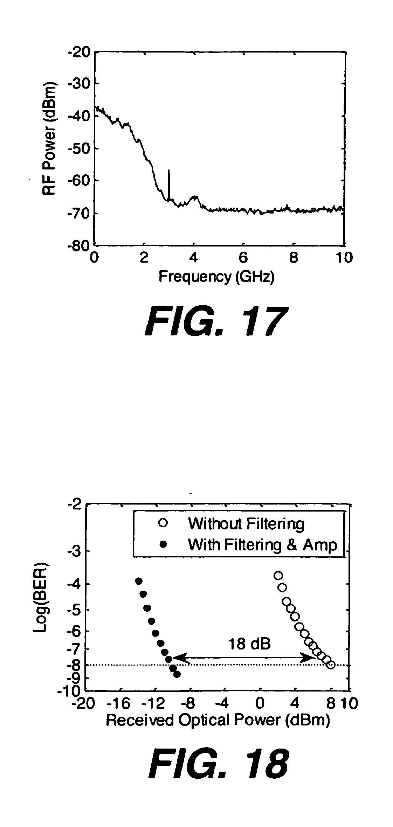

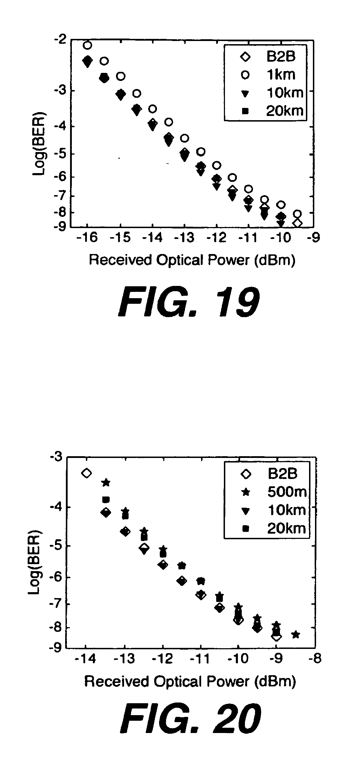

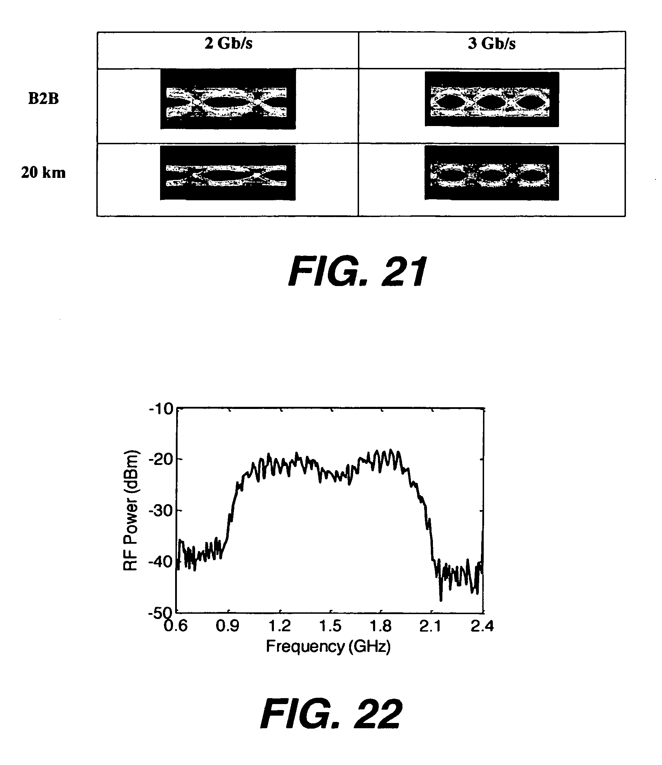

**FIG. 17** illustrates the electrical spectrum of 3 Gbps PRBS-31 ASK signal down-converted after transmission over 20 km of standard single-mode fiber and 3m wireless distance. The impact of the CSR equalization on the sensitivity of the ASK-modulated RoF system is shown in **FIG. 18. FIG. 18** illustrates improvement in the receiver sensitivity of the RoF system due to carrier-to-sideband power ratio equalization for 2 Gbps ASK data modulation without fiber and wireless transmission. There was a very significant improvement in the system sensitivity by 18 dB for 2 Gbps ASK-data modulation, as shown. The improved sensitivity indicated that fiber transmission distances much longer than the 10 km achieved in the un-equalized RoF system would be feasible. This was confirmed by the BER performance results of the CSR-equalized RoF system shown in **FIG. 19** and **FIG. 20** for 2 Gbps and 3 Gbps ASK data transmission, respectively. In both cases, 20 km fiber transmission distance was achieved with very good sensitivities and negligible power penalties with respect to the B2B system performance. Referring to **FIG. 19****,** for 2 Gbps ASK data (PRBS -31) modulation and 20km fiber transmission distance, the sensitivities were -14.0 dBm and -10.5 dBm at the BERs of 1x10⁻⁴ and 1x10⁻⁸, respectively. Referring to **FIG. 20****,** for 3 Gbps, the corresponding sensitivities were-13.0 dBm and -9.5 dBm, respectively. Therefore, the difference in the system sensitivities at the two data-rates was 1 dB. **FIG. 19** and **FIG. 20** show some error flooring, but at much lower BERs closer to error-free transmission (1x10⁻⁹). In both cases, the fluctuation in sensitivity for the different fiber transmission distances was less than 0.5 dB, which was attributed to the interaction between signal chirp and fiber dispersion.. The eye diagrams of received ASK data before and after transmission over 20 km of standard single-mode fiber and 3 m wireless distance are shown in **FIG. 21****.** Clearly open eye diagrams were observed after 20km of fiber transmission as shown in **FIG. 21****.**

### Results for QPSK Data Modulation

To test the performance of the CSR-equalized OIL RoF system with complex multi-level modulation formats, the PPG in **FIG. 14** was replaced with an Arbitrary Waveform Generator (AWG), which was used to generate wideband QPSK signals. After transmission over fiber and 3 m wireless distance, the recovered signal was analyzed by a Vector Signal Analyzer. **FIG. 22** shows the spectrum of the recovered 2 Gbps QPSK signal (PRBS-9) modulated on a 1.5 GHz sub-carrier. The received optical power was -8 dBm with the corresponding Error Vector Magnitude (EVM) and SNR equal to 15.0% and 16.4 dB, respectively. The small dip (∼ 2dB) observed in the centre of the spectrum comes from the frequency response of the end-to-end RoF link. Because of the wide spectrum of the transmitted signal (∼ 1 GHz), DSB modulation/demodulation was used in the 60 GHz up/down-converters. Using SSB modulation in the electrical up/down-converters would result in a less flattened spectrum, and, consequently ISI, which would require equalization (e.g. FFE) to achieve good system performance.

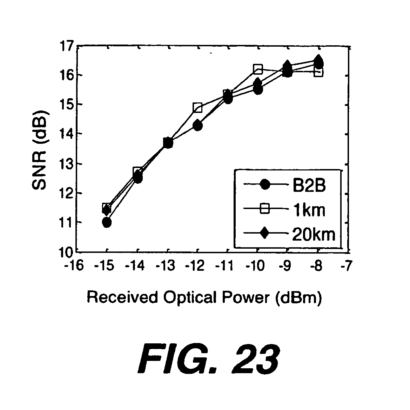

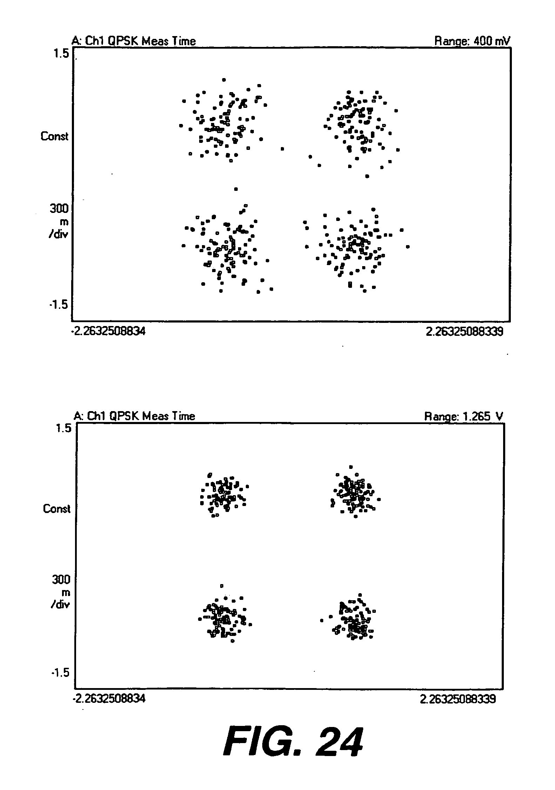

Measurement results for fiber transmission experiments are summarized in **FIG. 23****,** which illustrates measured SNR performance of the 60 GHz RoF system modulated with 2 Gbps QPSK data after transmission over up to 20 km of standard single-mode fiber and 3 m wireless distance. As was the case in the ASK experiments, no dispersion penalty was observed for QPSK modulated data over fiber transmission distances up-to 20 km (including 3m wireless distance), as shown. This was due to the optical SSB modulation employed, which in the CSR equalized case was aided by the filtering. Very clear constellation diagrams were obtained as shown in **FIG. 24****.** The constellation diagrams are of recovered 2 Gbps QPSK signal of the RoF system after transmission over 20 km of standard single-mode fiber and 3 m wireless distance. EVM was 27% and 15% at -15 dBm (top) and -8 dBm (bottom) received optical power, respectively.

As shown in **FIG. 23****,** the sensitivity of the 2Gbps QPSK-modulated system at the BER of 1x10⁻³ corresponding to a SNR of 10 dB was less than -15 dBm. This is similar to the sensitivity of the ASK modulated system at the same data-rate. When a lower data-rate of 1 Gbps was used, the measured SNR was much higher (i.e. 20.7 dB at - 10.0 dBm received optical power, and 20 km fiber transmission) and the sensitivity was much higher. These results for QPSK transmission were made possible by the improved link efficiency due to CSR equalization employed. These results demonstrate that the CSR-equalized RoF system can support fiber lengths much longer than 20km and much higher data-rates through the use of much higher order modulation formats such as 8-QAM, and 16-QAM, which are more spectrally efficient than ASK and QPSK modulation formats.

The devices and methods disclosed herein are advantageous in that they enable the optical power ratio between the carrier signal component and the sideband signal component to be adjusted independently of the injection ratio (ratio of the optical power of the master laser to the optical power of the slave laser). As a result, the optical power ratio between the carrier signal component and the sideband signal component can be optimized while also maintaining an optimized injection ratio. Furthermore, the devices and methods provide higher optical link efficiency by providing higher received RF power, which enables higher transmitted wireless power for a given transmitted optical power. Higher bit rates are also enabled because equalizing the optical power ratio between the carrier signal component and the sideband signal component results in a higher SNR, which makes it possible to employ spectrally efficient complex modulation formats (e.g., QPSK, quadrature amplitude modulation (xQAM), optical frequency-division multiplexing (OFDM)). Additionally, by reducing the carrier signal component power through filtering, the devices significantly reduce the power launched into the transmission channel to well below the stimulated Brillouin scattering (SBS) threshold of long fiber spans. Furthermore, by attenuating the carrier signal component, it is possible to use amplifiers to extend the reach of the optical link between the device and components receiving transmissions from the device. Longer wireless transmission distances are also possible due to the combination of high link efficiency, high generated RF power, and high RF signal SNR.

The devices and methods disclosed herein also provide a low cost, low complexity and reliable solution for obtaining the above benefits. For example, in the embodiment of **FIGS. 1 and 2**, the bandpass filter is inexpensive and less sensitive to environmental conditions, such as temperature, in comparison to the notch filters (e.g., fiber Bragg gating (FBG) filters) and other narrow band filters commonly used in conventional optical transmission devices. In the embodiments of **FIGS. 4** and **5**, cost and complexity are reduced by employing a single optical element to perform the functions of routing the optical signals and optimizing the optical power ratio between the carrier signal component and the sideband signal component. The embodiment of **FIG. 6** reduces the cost of a system employing multiple transmitters by using a single master laser to lock multiple slave lasers without having to split the power from the master laser.

## Claims

1. An optical transmission device comprising:
a master laser (20) configured to generate a master signal (S1);
a Vertical-Cavity Surface-Emitting Laser (VCSEL) (80; 270) configured for optical injection locking by the master laser (20), and configured to generate a VCSEL output signal comprising a carrier component and a modulated sideband component; and **characterized by**
an equalizer unit (90; 140; 190; 230) configured to receive the VCSEL output signal and output an equalized output signal having a reduced ratio of carrier component power to modulated sideband component power in comparison to the VCSEL output signal.

2. The optical transmission device of claim 1, wherein:
the equalizer unit (90; 140: 190; 230) comprises an optical filter (140, 160; 240, 250) configured to attenuate the first carrier component to output the equalized output signal, the optical filter (140, 160; 240, 250) comprising a bandpass filter, a low-pass filter or a band-stop filter; and
the optical transmission device comprises an optical circulator (70; 260) coupled to the master laser (20) and the VCSEL (80; 270), wherein the optical circulator (70; 260) is configured to route the master signal to the VCSEL (80; 270) and route the VCSEL output signal to the optical filter (140, 160; 240, 250).

3. The optical transmission device of claims 1-2, comprising an optical amplifier (120; 300) configured to amplify the equalized output signal.

4. The optical transmission device of claim 1, wherein:
the equalizer unit (140; 190; 230) comprises a first three-port optical filter (150; 240), the first three-port optical filter (150; 240) being configured to
receive the VCSEL output signal from the VCSEL (80; 270),
separate the carrier component and the modulated sideband component, and
separately transmit the carrier component and the modulated sideband component; and
the optical transmission device comprises a first optical circulator (70; 260) configured to route the master signal to the first VCSEL (80) and route the VCSEL output signal to the first three-port optical filter (150; 240).

5. The optical transmission device of claim 4, wherein the equalizer unit (140) comprises:
a variable optical attenuator (170) configured to receive the carrier component from the first three-port optical filter (70) and attenuate the carrier component to form an attenuated carrier component; and
a second three-port optical filter (160) or a three-port optical power coupler, wherein the second three-port optical filter (160) or three-port optical power coupler is configured to combine the attenuated carrier component and the modulated sideband component to output the equalized output signal.

6. The optical transmission device of claim 4, wherein the equalizer unit (140) comprises:
an optical amplifier configured to receive the modulated sideband component from the first three-port optical filter (150) and amplify the modulated sideband component to form an amplified sideband component; and
a second three-port optical filter (160) or a three-port optical power coupler, wherein the second three-port optical filter (160) or three-port optical power coupler is configured to combine the carrier component and the amplified sideband component to output the equalized output signal.

7. The optical transmission device of claim 1, wherein the equalizer unit (140; 190; 230) comprises a three-port optical filter (150; 240) configured to:
receive the master signal;
route the master signal to the VCSEL (80; 270);
receive the VCSEL output signal from the VCSEL (80; 270);
reflect or absorb a first portion of the carrier component; and
output the modulated sideband component and a second portion of the carrier component to form the equalized output signal.

8. The optical transmission device of claim 7, comprising an optical isolator (210) configured to:
receive the master signal from the master laser (20);
transmit the master signal to the three-port optical filter (190) ; and
absorb the first portion of the carrier component.

9. The optical transmission device of claim 1, wherein the equalizer unit (90) comprises an optical amplifier (120; 300) configured to provide a wavelength-dependent optical gain or a wavelength-dependent optical loss, and wherein the amplifier (90, 300) is configured to receive the VCSEL output signal and either amplify the modulated sideband component or attenuate the carrier component to output the equalized output signal.

10. An optical transmission method comprising:
injection locking a Vertical-Cavity Surface-Emitting Laser (VCSEL) (80; 270) by a master laser (20);
operating the VCSEL (80; 270) to generate a VCSEL output signal comprising a carrier component and a modulated sideband component; **characterized by**
transmitting the VCSEL output signal to an equalizer unit (90; 140; 190; 230);
forming an equalized output signal in the equalizer unit (90; 140; 190; 230), wherein the equalized output signal comprises a reduced ratio of carrier component power to modulated sideband component power in comparison to the VCSEL output signal; and
outputting the equalized output signal.

11. The method of claim 10, comprising:
routing a master signal from the master laser (20) to the VCSEL (80; 270) via an optical circulator (70; 260);
routing the VCSEL; output signal from the VCSEL (80; 270) to an optical filter (150, 160; 230, 240) in the equalizer unit (90; 140; 190; 230) via the optical circulator (70; 260), wherein the optical filter (150, 160; 230, 240) comprises a bandpass filter, a low-pass filter or a band-stop filter;
attenuating the carrier component in the optical filter (150, 160; 230, 240) to form the equalized output signal; and
outputting the equalized output signal from the optical filter (150, 160; 230, 240).

12. The method of claim 11, comprising amplifying the equalized output signal with an optical amplifier (120; 300).

13. the method of claim 10, comprising:
routing the master signal to the VCSEL (80) via a first optical circulator (70);
routing the VCSEL output signal to a first three-port optical filter (150) in the equalizer unit (140) via the first optical circulator (70);
separating the carrier component and the modulated sideband component with the first three-port optical filter (150); and
separately transmitting the carrier component and the modulated sideband component from the first three-port optical filter (150).

14. The method of claim 13, comprising:
passing the carrier component through a variable optical attenuator (170) in the equalizer (140) unit to form an attenuated carrier component;
transmitting the attenuated carrier component to a second three-port optical filter (160) or a three-port optical power coupler in the equalizer unit (140);
combining the attenuated carrier component and the modulated sideband component in the second three-port optical filter (160) or three-port optical power coupler to form the equalized output signal; and
outputting the equalized output signal from the second three-port optical filter (160) or three-port optical power coupler.

15. The method of claim 13, comprising:
transmitting the carrier component to a second three-port optical filter (160) or a three-port optical power coupler in the equalizer unit;
amplifying the modulated sideband component in the equalizer unit (140) with an optical amplifier (300) to form an amplified sideband component;
transmitting the amplified sideband component to the second three-port optical filter (160) or three-port optical power coupler;
combining the carrier component and the amplified sideband component in the second three-port optical filter (160) or three-port optical power coupler to form the equalized output signal; and
outputting the equalized output signal from the second three-port optical filter (160) or three-port optical power coupler.

16. The method of claim 10, comprising:
routing a master signal from the master laser (20) to the VCSEL (80) via a three-port optical filter (190) ;
routing the VCSEL output signal to the three-port optical filter (190);
reflecting or absorbing a first portion of the carrier component in the three-port optical filter (190); and
outputting the modulated sideband component and a second portion of the carrier component from the three-port optical filter (190) to form the equalized output signal.

17. The method of claim 16, wherein routing the master signal from the master laser (20) to the VCSEL (80) comprises routing the master signal through an optical isolator (210), and wherein the method comprises:
directing the first portion of the carrier component to the optical isolator (210); and
absorbing the first portion of the carrier component in the optical isolator (210).

## Patentansprüche

1. Optische Übertragungseinrichtung, die Folgendes umfasst:
einen Hauptlaser (20), der konfiguriert ist zum Generieren eines Hauptsignals (S1);
einen VCSEL (Vertical Cavity Surface Emitting Laser) (80; 270), der konfiguriert ist zum optischen Injection-Locking durch den Hauptlaser (20) und konfiguriert ist zum Generieren eines VCSEL-Ausgangssignals, umfassend eine Trägerkomponente und eine modulierte Seitenwandkomponente; und **gekennzeichnet durch**
eine Entzerrereinheit (90; 140; 190; 230), die konfiguriert ist zum Empfangen des VCSEL-Ausgangssignals und Ausgeben eines entzerrten Ausgangssignals mit einem reduzierten Verhältnis von Trägerkomponentenleistung zu modulierter Seitenbandkomponentenleistung im Vergleich zu dem VCSEL-Ausgangssignal.

2. Optische Übertragungseinrichtung nach Anspruch 1, wobei:
die Entzerrereinheit (90; 140; 190; 230) ein optisches Filter (140, 160; 240, 250) umfasst, das konfiguriert ist zum Dämpfen der ersten Trägerkomponente zum Ausgeben des entzerrten Ausgangssignals, wobei das optische Filter (140, 160; 240, 250) ein Bandpassfilter, ein Tiefpassfilter und ein Bandsperrfilter umfasst; und
die optische Übertragungseinrichtung einen optischen Zirkulator (70; 260) umfasst, der an den Hauptlaser (20) und den VCSEL (80; 270) gekoppelt ist, wobei der optische Zirkulator (70; 260) konfiguriert ist zum Lenken des Hauptsignals zu dem VCSEL (80, 270) und Senken des VCSEL-Ausgangssignals zu dem optischen Filter (140, 160; 240, 250).

3. Optische Übertragungseinrichtung nach Ansprüchen 1-2, umfassend einen optischen Verstärker (120; 300), der konfiguriert ist zum Verstärken des entzerrten Ausgangssignals.

4. Optische Übertragungseinrichtung nach Anspruch 1, wobei:
die Entzerrereinheit (140; 190; 230) ein erstes optisches Drei-Port-Filter (150; 240) umfasst, wobei das erste optische Drei-Port-Filter (150; 240) konfiguriert ist zum
Empfangen des VCSEL-Ausgangssignals von dem VCSEL (80; 270),
Trennen der Trägerkomponente und der modulierten Seitenbandkomponente und
getrennten Übertragen der Trägerkomponente und der modulierten Seitenbandkomponente; und
die optische Übertragungseinrichtung einen ersten optischen Zirkulator (70; 260) umfasst, der konfiguriert ist zum Lenken des Hauptsignals zu dem ersten VCSEL (80) und Lenken des VCSEL-Ausgangssignals zu dem ersten optischen Drei-Port-Filter (150; 240).

5. Optische Übertragungseinrichtung nach Anspruch 4, wobei die Entzerrereinheit (140) Folgendes umfasst:
ein variables optisches Dämpfungsglied (170), das konfiguriert ist zum Empfangen der Trägerkomponente von dem ersten optischen Drei-Port-Filter (70) und Dämpfen der Trägerkomponente zum Ausbilden einer gedämpften Trägerkomponente; und
ein zweites optisches Drei-Port-Filter (160) oder einen optischen Drei-Port-Leistungskoppler, wobei das zweite optische Drei-Port-Filter (160) oder der optische Drei-Port-Leistungskoppler konfiguriert ist zum Verknüpfen der gedämpften Trägerkomponente und der modulierten Seitenbandkomponente, zum Ausgeben des entzerrten Ausgangssignals.

6. Optische Übertragungseinrichtung nach Anspruch 4, wobei die Entzerrereinheit (140) Folgendes umfasst:
einen optischen Verstärker, der konfiguriert ist zum Empfangen der modulierten Seitenbandkomponente von dem ersten optischen Drei-Port-Filter (150) und Verstärken der modulierten Seitenbandkomponente zum Ausbilden einer verstärkten Seitenbandkomponente; und
ein zweites optisches Drei-Port-Filter (160) oder einen optischen Drei-Port-Leistungskoppler, wobei das zweite optische Drei-Port-Filter (160) oder der optische Drei-Port-Leistungskoppler konfiguriert ist zum Verknüpfen der Trägerkomponente und der verstärkten Seitenbandkomponente, zum Ausgeben des entzerrten Ausgangssignals.

7. Optische Übertragungseinrichtung nach Anspruch 1, wobei die Entzerrereinheit (140; 190; 230) ein optisches Drei-Port-Filter (150; 240) umfasst, das konfiguriert ist zum:
Empfangen des Hauptsignals;
Lenken des Hauptsignals zu dem VCSEL (80; 270);
Empfangen des VCSEL-Ausgangssignals von dem VCSEL (80; 270);
Reflektieren oder Absorbieren eines ersten Teils der Trägerkomponente und
Ausgeben der modulierten Seitenbandkomponente und eines zweiten Teils der Trägerkomponente zum Ausbilden des entzerrten Ausgangssignals.

8. Optische Übertragungseinrichtung nach Anspruch 7, umfassend einen optischen Isolator (210), der konfiguriert ist zum:
Empfangen des Hauptsignals von dem Hauptlaser (20);
Übertragen des Hauptsignals zu dem optischen Drei-Port-Filter (190) und
Absorbieren des ersten Teils der Trägerkomponente.

9. Optische Übertragungseinrichtung nach Anspruch 1, wobei die Entzerrereinheit (90) einen optischen Verstärker (120; 300) umfasst, der konfiguriert ist zum Bereitstellen eines wellenlängenabhängigen optischen Verstärkungsfaktors oder eines wellenlängenabhängigen optischen Verlusts, und wobei der Verstärker (90, 300) konfiguriert ist zum Empfangen des VCSEL-Ausgangssignals und entweder Verstärken der modulierten Seitenbandkomponente oder Dämpfen der Trägerkomponente zum Ausgeben des entzerrten Ausgangssignals.

10. Optisches Übertragungsverfahren, das Folgendes umfasst:
Injection-Locking eines VCSEL (Vertical Cavity Surface Emitting Laser) (80; 270) durch einen Hauptlaser (20);
Betreiben des VCSEL (80; 270) zum Generieren eines VCSEL-Ausgangssignals, umfassend eine Trägerkomponente und eine modulierte Seitenbandkomponente; **gekennzeichnet durch**:
Übertragen des VCSEL-Ausgangssignals zu einer Entzerrereinheit (90; 140; 190; 230);
Ausbilden eines entzerrten Ausgangssignals in der Entzerrereinheit (90; 140; 190; 230), wobei das entzerrte Ausgangssignal ein reduziertes Verhältnis von Trägerkomponentenleistung zu modulierter Seitenbandkomponentenleistung im Vergleich zu dem VCSEL-Ausgangssignal umfasst; und
Ausgeben des entzerrten Ausgangssignals.

11. Verfahren nach Anspruch 10, das Folgendes umfasst:
Lenken eines Hauptsignals von dem Hauptlaser (20) zu dem VCSEL (80; 270) über einen optischen Zirkulator (70; 260);
Lenken des VCSEL-Ausgangssignals von dem VCSEL (80; 270) zu einem optischen Filter (150, 160; 230, 240) in der Entzerrereinheit (90; 140; 190; 230) über den optischen Zirkulator (70; 260), wobei das optische Filter (150, 160; 230, 240) ein Bandpassfilter, ein Tiefpassfilter und ein Bandsperrfilter umfasst;
Dämpfen der Trägerkomponente in dem optischen Filter (150, 160; 230, 240) zum Ausbilden des entzerrten Ausgangssignals und
Ausgeben des entzerrten Ausgangssignals aus dem optischen Filter (150, 160; 230, 240).

12. Verfahren nach Anspruch 11, umfassend das Verstärken des entzerrten Ausgangssignals mit einem optischen Verstärker (120; 300).

13. Verfahren nach Anspruch 10, das Folgendes umfasst:
Lenken des Hauptsignals zu dem VCSEL (80) über einen ersten optischen Zirkulator (70);
Lenken des VCSEL-Ausgangssignals zu einem ersten optischen Drei-Port-Filter (150) in der Entzerrereinheit (140) über den ersten optischen Zirkulator (70);
Trennen der Trägerkomponente und der modulierten Seitenbandkomponente mit dem ersten optischen Drei-Port-Filter (150) und
getrenntes Übertragen der Trägerkomponente und der modulierten Seitenbandkomponente von dem ersten optischen Drei-Port-Filter (150).

14. Verfahren nach Anspruch 13, das Folgendes umfasst:
Leiten der Trägerkomponente durch ein variables optisches Dämpfungsglied (170) in der Entzerrereinheit (140) zum Ausbilden einer gedämpften Trägerkomponente;
Übertragen der gedämpften Trägerkomponente zu einem zweiten optischen Drei-Port-Filter (160) oder einem optischen Drei-Port-Leistungskoppler in der Entzerrereinheit (140);
Verknüpfen der gedämpften Trägerkomponente und der modulierten Seitenbandkomponente in dem zweiten optischen Drei-Port-Filter (160) oder dem optischen Drei-Port-Leistungskoppler zum Ausbilden des entzerrten Ausgangssignals; und
Ausgeben des entzerrten Ausgangssignals von dem zweiten optischen Drei-Port-Filter (160) oder dem optischen Drei-Port-Leistungskoppler.

15. Verfahren nach Anspruch 13, das Folgendes umfasst:
Übertragen der Trägerkomponente zu einem zweiten optischen Drei-Port-Filter (160) oder einem optischen Drei-Port-Leistungskoppler in der Entzerrereinheit;
Verstärken der modulierten Seitenbandkomponente in der Entzerrereinheit (140) mit einem optischen Verstärker (300) zum Ausbilden einer verstärkten Seitenbandkomponente;
Übertragen der verstärkten Seitenbandkomponente zu dem zweiten optischen Drei-Port-Filter (160) oder optischen Drei-Port-Leistungskoppler;
Verknüpfen der Trägerkomponente und der verstärkten Seitenbandkomponente in dem zweiten optischen Drei-Port-Filter (160) oder optischen Drei-Port-Leistungskoppler zum Ausbilden des entzerrten Ausgangssignals; und
Ausgeben des entzerrten Ausgangssignals von dem zweiten optischen Drei-Port-Filter (160) oder optischen Drei-Port-Leistungskoppler.

16. Verfahren nach Anspruch 10, das Folgendes umfasst:
Lenken eines Hauptsignals von dem Hauptlaser (20) zu dem VCSEL (80) über ein optisches Drei-Port-Filter (190);
Lenken des VCSEL-Ausgangssignals zu dem optischen Drei-Port-Filter (190);
Reflektieren oder Absorbieren eines ersten Teils der Trägerkomponente in dem optischen Drei-Port-Filter (190) und
Ausgeben der modulierten Seitenbandkomponente und eines zweiten Teils der Trägerkomponente von dem optischen Drei-Port-Filter (190) zum Ausbilden des entzerrten Ausgangssignals.

17. Verfahren nach Anspruch 16, wobei das Lenken des Hauptsignals von dem Hauptlaser (20) zu dem VCSEL (80) das Lenken des Hauptsignals durch einen optischen Isolator (210) umfasst, und wobei das Verfahren Folgendes umfasst:
Lenken des ersten Teils der Trägerkomponente zu dem optischen Isolator (210) und
Absorbieren des ersten Teils der Trägerkomponente in dem optischen Isolator (210).

## Revendications

1. Dispositif de transmission optique comprenant:
un laser maître (20) conçu pour générer un signal maître (S1) ;
un laser à émission de surface à cavité verticale (VCSEL) (80 ; 270) conçu pour un verrouillage en injection optique par le laser maître (20), et conçu pour générer un signal de sortie de VCSEL comprenant une composante de porteuse et une composante de bande latérale modulée ; et **caractérisé en ce que** :
une unité d'égaliseur (90 ; 140 ; 190 ; 230) est conçue pour recevoir le signal de sortie du VCSEL et émettre un signal de sortie égalisé possédant un rapport réduit entre la puissance de la composante de porteuse et la puissance de la composante de bande latérale modulée par rapport au signal de sortie du VCSEL.

2. Dispositif de transmission optique selon la revendication 1, dans lequel :
l'unité d'égaliseur (90 ; 140 ; 190 ; 230) comprend un filtre optique (140, 160 ; 240, 250) conçu pour atténuer la première composante de porteuse afin d'émettre le signal de sortie égalisé, le filtre optique (140, 160 ; 240, 250) comprenant un filtre de bande passante, un filtre passe-bas ou un filtre d'arrêt de bande ; et
le dispositif de transmission optique comprend un circulateur optique (70 ; 260) couplé au laser maître (20) et au VCSEL (80 ; 270), lequel circulateur optique (70 ; 260) est conçu pour router le signal maître vers le VCSEL (80 ; 270) et pour router le signal de sortie du VCSEL vers le filtre optique (140, 160 ; 240, 250).

3. Dispositif de transmission optique selon les revendications 1-2, comprenant un amplificateur optique (120 ; 300) conçu pour amplifier le signal de sortie égalisé.

4. Dispositif de transmission optique selon la revendication 1, dans lequel :
l'unité d'égaliseur (140 ; 190 ; 230) comprend un premier filtre optique à trois ports (150 ; 240) qui est conçu pour :
recevoir le signal de sortie du VCSEL provenant du VCSEL (80 ; 270) ;
séparer la composante de porteuse et la composante de bande latérale modulée ; et
transmettre séparément la composante de porteuse et la composante de bande latérale modulée ; et
le dispositif de transmission optique comprend un premier circulateur optique (70 ; 260) conçu pour router le signal maître vers le premier VCSEL (80) et pour router le signal de sortie du VCSEL vers le premier filtre optique à trois ports (150 ; 240) ;

5. Dispositif de transmission optique selon la revendication 4, dans lequel l'unité d'égaliseur (140) comprend :
un atténuateur optique variable (170) conçu pour recevoir la composante de porteuse depuis le premier filtre optique à trois ports (70) et pour atténuer la composante de porteuse afin de former une composante de porteuse atténuée ; et
un second filtre optique à trois ports (160) ou un coupleur de puissance optique à trois ports, lequel second filtre optique à trois ports (160) ou coupleur de puissance optique à trois ports est conçu pour combiner la composante de porteuse atténuée et la composante de bande latérale modulée afin d'émettre le signal de sortie égalisé.

6. Dispositif de transmission optique selon la revendication 4, dans lequel l'unité d'égaliseur (140) comprend :
un amplificateur optique conçu pour recevoir la composante de bande latérale modulée depuis le premier filtre optique à trois ports (150), et amplifier la composante de bande latérale modulée afin de former une composante de bande latérale amplifiée ; et
un second filtre optique à trois ports (160) ou un coupleur de puissance optique à trois ports, lequel second filtre optique à trois ports (160) ou coupleur de puissance optique à trois ports est conçu pour combiner la composante de porteuse et la composante de bande latérale amplifiée afin d'émettre le signal de sortie égalisé.

7. Dispositif de transmission optique selon la revendication 1, dans lequel l'unité d'égaliseur (140 ; 190 ; 230) comprend un filtre optique à trois ports (150 ; 240) conçu pour :
recevoir le signal maître ;
router le signal maître vers le VCSEL (80 ; 270) ;
recevoir le signal de sortie du VCSEL depuis le VCSEL (80 ; 270) ;
réfléchir ou absorber une première partie de la composante de porteuse ; et
émettre la composante de bande latérale modulée et une seconde partie de la composante de porteuse de manière à former le signal de sortie égalisé.

8. Dispositif de transmission optique selon la revendication 7, comprenant un isolateur optique (210) conçu pour :
recevoir le signal maître depuis le laser maître (20) ;
transmettre le signal maître vers le filtre optique à trois ports (190) ; et
Absorber la première partie de la composante de porteuse.

9. Dispositif de transmission optique selon la revendication 1, dans lequel l'unité d'égaliseur (90) comprend un amplificateur optique (120 ; 300) conçu pour fournir un gain optique dépendant de la longueur d'onde ou une perte optique dépendant de la longueur d'onde, et dans lequel l'amplificateur (90, 300) est conçu pour recevoir le signal de sortie du VCSEL, et pour amplifier la composante de bande latérale modulée ou atténuer la composante de porteuse afin d'émettre le signal de sortie égalisé.

10. Procédé de transmission optique consistant à :
verrouiller en injection un laser à émission de surface à cavité verticale (VCSEL) (80 ; 270) par un laser maître (20) ;
actionner le VCSEL (80 ; 270) afin de générer un signal de sortie du VCSEL comprenant une composante de porteuse et une composante de bande latérale modulée ; **caractérisé en ce qu'**il consiste à :
transmettre le signal de sortie du VCSEL vers une unité d'égaliseur (90 ; 140 ; 190 ; 230) ;
former un signal de sortie égalisé dans l'unité d'égaliseur (90 ; 140 ; 190 ; 230), lequel signal de sortie égalisé possède un rapport réduit entre la puissance de la composante de porteuse et la puissance de la composante de bande latérale modulée par rapport au signal de sortie du VCSEL ; et
émettre le signal de sortie égalisé.

11. Procédé selon la revendication 10, consistant à :
router un signal maître depuis le laser maître (20) vers le VCSEL (80 ; 270) via un circulateur optique (70 ; 260) ;
router le signal de sortie du VCSEL depuis le VCSEL (80 ; 270) vers un filtre optique (150, 160 ; 230, 240) dans l'unité d'égaliseur (90 ; 140 ; 190 ; 230) via le circulateur optique (70 ; 260), lequel filtre optique (150, 160 ; 230, 240) comprend un filtre passe-bas ou un filtre d'arrêt de bande ;
atténuer la composante de porteuse dans le filtre optique (150, 160 ; 230, 240) afin de former le signal de sortie égalisé ; et
émettre le signal de sortie égalisé depuis le filtre optique (150, 160 ; 230, 240).

12. Procédé selon la revendication 11, consistant à amplifier le signal de sortie égalisé à l'aide d'un amplificateur optique (120 ; 300).

13. Procédé selon la revendication 10, consistant à :
router le signal maître vers le VCSEL (80) via un premier circulateur optique (70) ;
router le signal de sortie du VCSEL vers un premier filtre optique à trois ports (150) dans l'unité d'égaliseur (140) via le premier circulateur optique (70) ;
séparer la composante de porteuse et la composante de bande de base modulée à l'aide du premier filtre optique à trois ports (150) ; et
transmettre séparément la composante de porteuse et la composante de bande latérale modulée depuis le premier filtre optique à trois ports (150).

14. Procédé selon la revendication 13, consistant à :
faire passer la composante de porteuse à travers un atténuateur optique variable (170) dans l'unité d'égaliseur (140) afin de former une composante de porteuse atténuée ;
transmettre la composante de porteuse atténuée vers un second filtre optique à trois ports (160) ou un coupleur de puissance optique à trois ports dans l'unité d'égaliseur (140) ;
combiner la composante de porteuse atténuée et la composante de bande latérale modulée dans le second filtre optique à trois ports (160) ou le coupleur de puissance optique à trois ports afin de former le signal de sortie égalisé ; et
émettre le signal de sortie égalisé depuis le second filtre optique à trois ports (160) ou le coupleur de puissance optique à trois ports.

15. Procédé selon la revendication 13, consistant à :
transmettre la composante de porteuse vers un second filtre optique à trois ports (160) ou coupleur de puissance optique à trois ports dans l'unité d'égaliseur ;
amplifier la composante de bande latérale modulée dans l'unité d'égaliseur (140) à l'aide d'un amplificateur optique (300) afin de former une composante de bande latérale amplifiée ;
transmettre la composante de bande latérale amplifiée vers le second filtre optique à trois ports (160) ou coupleur de puissance optique à trois ports ;
combiner la composante de porteuse et la composante de bande latérale amplifiée dans le second filtre optique à trois ports (160) ou coupleur de puissance optique à trois ports afin de former un signal de sortie égalisé ; et
émettre le signal de sortie égalisé depuis le second filtre optique à trois ports (160) ou coupleur de puissance optique à trois ports.

16. Procédé selon la revendication 10, consistant à :
router un signal maître depuis le laser maître (20) vers le VCSEL (80) via un filtre optique à trois ports (190) ;
router le signal de sortie du VCSEL vers le filtre optique à trois ports (190) ;
réfléchir ou absorber une première partie de la composante de porteuse dans le filtre optique à trois ports (190) ; et
émettre la composante de bande latérale modulée et une seconde partie de la composante de porteuse depuis le filtre optique à trois ports (190) afin de former le signal de sortie égalisé.

17. Procédé selon la revendication 16, dans lequel le routage du signal maître depuis le laser maître (20) vers le VCSEL (80) consiste à router le signal maître à travers un isolateur optique (210), et lequel procédé consiste à :
router la première partie de la composante de porteuse vers l'isolateur optique (210) ; et
absorber la première partie de la composante de porteuse dans l'isolateur optique (210).
